(19) Europäisches Patentamt
European Patent Office
Office européen des brevets

(11) EP 2 479 611 B1

(12) **EUROPEAN PATENT SPECIFICATION**

(45) Date of publication and mention of the grant of the patent:
**15.10.2014 Bulletin 2014/42**

(21) Application number: **12151375.8**

(22) Date of filing: **17.01.2012**

(51) Int Cl.:
***G03F 7/004*** *(2006.01)*
***G03F 7/075*** *(2006.01)*
***H05K 1/00*** *(2006.01)*
***H05K 3/00*** *(2006.01)*
*G03F 7/039* *(2006.01)*

(54) **Chemically amplified positive resist composition and patterning process**

Chemisch verstärkte Positivlackzusammensetzung und Strukturierungsverfahren

Composition de réserve positive amplifiée chimiquement et procédé de formation de motifs

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **19.01.2011 JP 2011008942**

(43) Date of publication of application:
**25.07.2012 Bulletin 2012/30**

(73) Proprietor: **Shin-Etsu Chemical Co., Ltd.**
**Tokyo (JP)**

(72) Inventors:
- **Yasudo, Hiroyuki**
  **Annaka-shi, Gunma (JP)**
- **Takemura, Katsuya**
  **Joetsu-shi, Niigata (JP)**
- **Koike, Noriyuki**
  **Annaka-shi, Gunma (JP)**

(74) Representative: **Ter Meer Steinmeister & Partner**
**Patentanwälte**
**Mauerkircherstrasse 45**
**81679 München (DE)**

(56) References cited:
**EP-A1- 1 645 908**
**EP-A1- 1 724 332**
**EP-A2- 1 324 134**
**EP-A2- 1 798 596**
**JP-A- 2001 125 259**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 479 611 B1

## Description

### TECHNICAL FIELD

This invention relates to a resist composition which is exposed to UV radiation having a wavelength of at least 150 nm (near and deep-UV regions) and developed without leaving residue, known as "scum", and a pattern forming process. More particularly, it relates to a chemically amplified positive resist composition which is coated onto a substrate to form a relatively thick resist film of 5 to 100 μm thick, while improving coating uniformity and inhibiting a phenomenon that the thickness of resist coating is extremely increased at the periphery of the substrate, known as "edge crown" phenomenon.

### BACKGROUND ART

The resist material for use in the microfabrication of semiconductor integrated circuits is required to generate no resist residue or scum. The "scum" refers to insoluble resist components generated in the alkali development step following exposure. The presence of such scum after development is inconvenient to a subsequent etching or electrolytic plating step in that the scum causes etching or plating deficiency, leading to a fatal drawback that the desired finish profile is not obtainable. In the current situation where the line width becomes extremely fine, the presence of scum, even if slight, can raise a serious problem. One attempt to solve the scum problem is to add a specific surfactant to a commonly used developer which is an aqueous solution of an organic base such as tetramethylammonium hydroxide as disclosed in JP-A H06-118660 and JP-A H11-352700.

Approaches are also made from the resist material side. Regarding the chemically amplified resist material, JP-A H11-030856, JP-A H11-030865, and JP-A H11-109629 propose specific resins and acid generators. Since these methods intend to improve scum by modifying the resin or acid generator, they impose certain limits to some of the required properties of resist material. It would be desirable to have a scum improving method allowing for a choice of resin and acid generator from a wide range.

In harmony with the downsizing of electronic equipment, a rapid progress is recently made toward higher integration of LSIs and toward ASIC (application specific integrated circuits). For LSI mounting, multi-pin thin-film packaging is widely employed. Such multi-pin structures include protruding electrodes or solder bumps of at least 10 μm in height as the connecting terminal, while the technique for forming solder bumps is requisite. When bumps are formed on LSI by a plating technique, a photoresist material is used. While bumps of mushroom shape are formed using conventional thin film resist, such bump shape is difficult to increase the integration density by increasing the number of pins on LSI or reducing the pin spacing. It is then necessary to shape bumps with vertical sidewalls (or straight sidewalls) utilizing a thick film resist. Solder bumps are formed between features of a pattern formed of resist material by immersing the substrate in a plating bath and electrolytic plating. Since solder bumps must have a height of several tens of microns to about 100 microns (μm), the resist pattern formed therefor must accordingly have a depth of several tens of μm to about 100 μm. It is thus recommended that the resist material be coated as a very thick film having a thickness of several tens of μm to about 100 μm.

As the resist film becomes thicker, it becomes more difficult to coat the resist material to a uniform thickness. If a coating thickness of resist material is not uniform, solder bumps formed by electrolytic plating have varying heights, leading to the drawback of electrode bonding failure. For the step of coating the resist material to form a thick film having a thickness of several tens of μm to about 100 μm, it is desirable that the thickness of resist coating be uniform.

The technique most commonly used in the step of coating the resist material is spin coating. When the resist material is spin coated as a thick film, i.e., to a thickness of several tens of μm to about 100 μm, a phenomenon occurs that the thickness of resist coating is increased like a crown near the periphery or edge of the substrate, which is known as "edge crown." When a resist coating which is thicker only at the periphery of the substrate is patterned, there arises a problem that the size of the resist pattern in the thicker portion is deviated from the desired size. For example, when a pattern of spaces or contact holes is formed, the size of the pattern in the thicker resist portion near the substrate periphery is changed to be thinner than the desired size of spaces or smaller than the desired size of contact holes. A difference arises between the pattern size at the substrate center and the pattern size at the substrate periphery. The difference of the resist pattern size within the substrate implies that the size of solder bumps formed by electrolytic plating also differs. Still worse, a pattern cannot be formed if the thickness of resist coating is extremely increased only at the periphery of the substrate.

Since the resist material adapted for solder bump pattern formation is coated as a very thick film having a thickness of several tens of μm to about 100 μm, it may have problems with respect to sensitivity and resist pattern profile. While positive resist compositions comprising a novolac resin and a naphthoquinonediazide-containing compound are commonly used in the art, thick films thereof having a thickness of several tens of μm to about 100 μm are degraded in sensitivity, which reduces the productivity efficiency of pattern formation, causes the pattern profile to be tapered, and

leads to profile deficiency against the requirement to shape bumps with vertical sidewalls (or straight sidewalls). For this reason, the solder bump-forming resist material requiring a film thickness of several tens of μm to about 100 μm prefers a chemically amplified resist composition because a pattern with more vertical sidewalls can be formed at a higher sensitivity.

EP 1 724 332 A1 discloses a fluorinated organosilicon compound and a fluorochemical surfactant of specific formula. EP 1 798 596 A2 relates to a positive photoresist composition comprising an alkali soluble resin, a 1,2-quinonediazide compound, an organic solvent, and a fluorinated organosilicon compound of specific formula.

Citation List

Patent Document 1: JP-A H06-118660
Patient Document 2: JP-A H11-352700
Patent Document 3: JP-A H11-030856
Patent Document 4: JP-A H11-030865
Patent Document 5: JP-A H11-109629
Patent Document 6: JP-A 2002-006503
Patent Document 7: JP-A H03-047190

SUMMARY OF INVENTION

An object of the invention is to provide a chemically amplified positive resist composition which can be developed without leaving scum, and which can be coated to a relatively large thickness of several tens of Rm to 100 μm thick, while improving coating uniformity and inhibiting an edge crown phenomenon that the thickness of resist coating is extremely increased near the periphery of the substrate.

The inventors have found that a chemically amplified positive resist composition comprising (A) a polymer having an acidic functional group protected with an acid labile group, which is substantially alkali insoluble, but turns alkali soluble when the acid labile group is eliminated, and (B) an acid generator, and optionally, (D) a basic compound is improved by adding thereto a minor amount of (C) a nonionic fluorinated surfactant in the form of a perfluoroalkyl ethylene oxide adduct or a nonionic fluorinated organosiloxane compound containing a perfluoropolyether group and having a polyoxyalkylene type polyether bond. When the resist composition is coated onto a substrate, exposed to UV radiation, and developed to form a resist pattern, many advantages are obtained. Specifically, scum formation is eliminated, satisfactory coating uniformity is achieved in the step of coating the resist composition on the substrate, and an edge crown phenomenon that the thickness of resist coating is increased near the periphery of the substrate is inhibited.

In one aspect, the invention provides a chemically amplified positive resist composition adapted for exposure to UV radiation having a wavelength of at least 150 nm, comprising

(A) a polymer having an acidic functional group protected with an acid labile group, which is substantially alkali insoluble, but turns alkali soluble when the acid labile group is eliminated, and which is further defined by the characteristics of claim 1,
(B) an acid generator, and
(C) at least one nonionic fluorinated organosiloxane compound having the general formula (1).

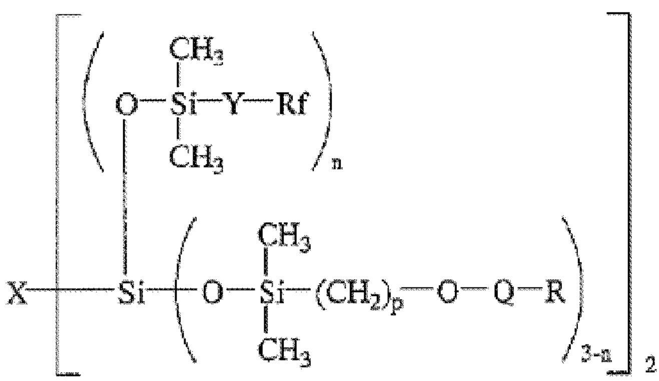

(1)

In formula (1), Rf is a perfluoroalkyl group of 5 to 30 carbon atoms containing at least one ether bond in the molecular chain, Q is a polyether group of a homopolymer chain of ethylene glycol or propylene glycol or a copolymer chain of ethylene glycol and propylene glycol, R is hydrogen or $C_1$-$C_4$ alkyl, X is a divalent linking group excluding oxygen atom, Y is a divalent linking group, p is an integer of at least 3, and n is a positive number in the range: $0 < n < 3$, wherein the nonionic fluorinated organosiloxane compound has a fluorine content of 7 to 35% by weight and a polyether content of 15 to 55% by weight, and p = 3-6 in formula (1).

Further aspects of the present invention are defined in the dependent claims.

In another aspect, the invention provides a pattern forming process comprising the steps of (i) coating the resist composition defined above onto a substrate and prebaking to form a resist film, (ii) exposing the resist film to UV radiation having a wavelength of at least 150 nm through a photomask, (iii) optionally baking, and developing with a developer to form a resist pattern, and optionally, (iv) electrolytic plating or electroless plating to deposit a metal layer on the substrate.

## ADVANTAGEOUS EFFECTS OF INVENTION

Many advantages are obtained when the resist composition of the invention is coated onto a substrate, exposed to UV radiation, and developed to form a resist pattern. No scum is left after development. Coating uniformity is ensured even when the composition is coated as a very thick coating of several tens of μm to 100 μm. An edge crown phenomenon that the thickness of resist coating is extremely increased at the periphery of the substrate is inhibited. Thus a satisfactory pattern can be formed.

## DESCRIPTION OF EMBODIMENTS

The singular forms "a," "an" and "the" include plural referents unless the context clearly dictates otherwise.

"Optional" or "optionally" means that the subsequently described event or circumstance may or may not occur, and that the description includes instances where the event occurs and instances where it does not.

As used herein, the notation ($C_n$-$C_m$) means a group containing from n to m carbon atoms per group.

The abbreviations and acronyms have the following meaning.

Mw: weight average molecular weight
Mn: number average molecular weight
Mw/Mn: molecular weight distribution or dispersity
GPC: gel permeation chromatography
PEB: post-exposure baking

As used herein, the term "substantially alkali insoluble" means that a polymer is insoluble or difficultly soluble in alkali.

One embodiment of the invention is a chemically amplified positive resist composition comprising (A) a polymer having an acidic functional group protected with an acid labile group, which is substantially alkali insoluble, but turns alkali soluble when the acid labile group is eliminated, (B) an acid generator, and (C) at least one nonionic fluorine compound selected from a nonionic fluorinated surfactant in the form of a perfluoroalkyl ethylene oxide adduct and a nonionic fluorinated organosiloxane compound containing a perfluoropolyether group and having a polyoxyalkylene type polyether bond. The composition is adapted for exposure to UV radiation having a wavelength of at least 150 nm.

Component (A) is a polymer having an acidic functional group protected with an acid labile group, which is substantially alkali insoluble, but turns alkali soluble when the acid labile group is eliminated, said polymer comprising recurring units having a phenolic hydroxyl group as represented by the general formula (3) wherein the hydrogen of phenolic hydroxyl group is, in part, substituted by an acid labile group of one or more type, in an average proportion of more than 0 mol% to 80 mol%, preferably 7 to 50 mol% based on the total hydrogen atoms of phenolic hydroxyl groups, the polymer having a weight average molecular weight (Mw) of 3,000 to 300,000, as measured by GPC versus polystyrene standards. More preferred are polyhydroxystyrene and derivatives thereof wherein the hydrogen of phenolic hydroxyl group is, in part, substituted by an acid labile group, having a Mw in the range and being monodisperse as demonstrated by a dispersity (Mw/Mn) of 1.0 to 2.5, more preferably 1.0 to 2.0.

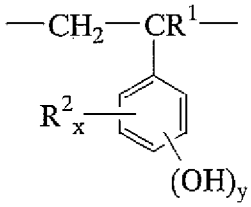

(3)

Herein $R^1$ is hydrogen or methyl, $R^2$ is a straight, branched or cyclic $C_1$-$C_8$ alkyl group, x is 0 or a positive integer, y is a positive integer, satisfying $x+y \leq 5$.

The acid labile group may be selected from a variety of such groups, preferably from groups having the general formulae (4) and (5), tert-alkyl, trialkylsilyl, and ketoalkyl groups.

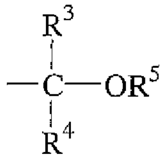

(4)

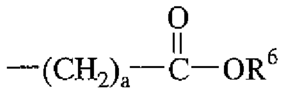

(5)

In formula (4), $R^3$ and $R^4$ are each independently hydrogen or a straight or branched $C_1$-$C_6$ alkyl group. $R^5$ is a straight, branched or cyclic $C_1$-$C_{10}$ alkyl group. Alternatively, a pair of $R^3$ and $R^4$, $R^3$ and $R^5$, or $R^4$ and $R^5$ may bond together to form a ring with the carbon atom or the carbon and oxygen atoms to which they are attached. Each of participant $R^3$, $R^4$ and $R^5$ is a straight or branched $C_1$-$C_6$ alkylene group when they form a ring.

Examples of the group having formula (4) include straight or branched acetal groups such as 1-ethoxyethyl, 1-n-propoxyethyl, 1-isopropoxyethyl, 1-n-butoxyethyl, 1-isobutoxyethyl, 1-sec-butoxyethyl, 1-tert-butoxyethyl, 1-tert-amyloxyethyl, 1-ethoxy-n-propyl, and 1-cyclohexyloxyethyl, and cyclic acetal groups such as tetrahydrofuranyl. Inter alia, 1-ethoxyethyl and 1-ethoxy-n-propyl are preferred.

In formula (5), $R^6$ is a tertiary alkyl group of 4 to 12 carbon atoms, preferably 4 to 8 carbon atoms, and more preferably 4 to 6 carbon atoms, and a is an integer of 0 to 6.

Examples of the group having formula (5) include tert-butoxycarbonyl, tert-butoxycarbonylmethyl, tert-amyloxycarbonyl, and tert-amyloxycarbonylmethyl.

Suitable tert-alkyl groups include tert-butyl, tert-amyl, and 1-methylcyclohexyl.

Suitable trialkylsilyl groups include those in which each alkyl moiety has 1 to 6 carbon atoms, such as trimethylsilyl, triethylsilyl, and dimethyl-tert-butylsilyl. Suitable ketoalkyl groups include 3-oxocyclohexyl and groups of the following formulae.

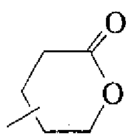 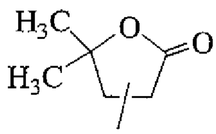

Another preferred example of the polymer (A) having an acidic functional group protected with an acid labile group, which is substantially alkali insoluble, but turns alkali soluble when the acid labile group is eliminated is a polymer comprising recurring units of formula (3) copolymerized with acrylate or methacrylate units of the general formula (6). Also preferred is a polymer comprising recurring units of formula (3) copolymerized with (meth)acrylate units of formula (6) wherein the hydrogen of phenolic hydroxyl group is, in part, substituted by an acid labile group as in the case of formula (3).

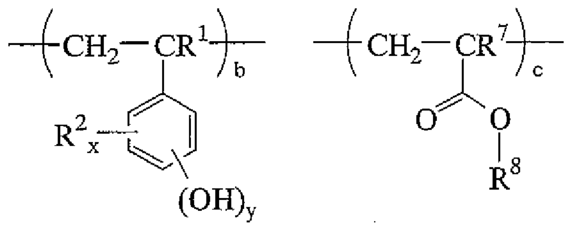

(6)

Herein $R^1$, $R^2$, x and y are as defined above. $R^7$ is hydrogen or methyl. $R^8$ is an acid labile group which is eliminated through reaction with acid, for example, tertiary alkyl of 4 to 20 carbon atoms, typically tert-butyl. The subscripts b and c are positive numbers, preferably in the range: $0.50 \leq b \leq 0.85$, $0.15 \leq c \leq 0.50$, and $b+c = 1$.

Component (B) is an acid generator, typically photoacid generator (PAG). It is any compound capable of generating an acid upon exposure to high-energy radiation. Suitable PAGs include sulfonium salt, iodonium salt, sulfonyldiazomethane, and N-sulfonyloxyimide acid generators. Exemplary acid generators are given below while they may be used alone or in admixture of two or more.

Sulfonium salts are salts of sulfonium cations with sulfonates. Exemplary sulfonium cations include triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-di-tert-butoxyphenyl)diphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl(2-naphthyl)sulfonium, 4-hydroxyphenyldimethylsulfonium, 4-methoxyphenyldimethylsulfonium, trimethylsulfonium, 2-oxocyclohexylcyclohexylmethylsulfonsum, trinaphthylsulfonium, and tribenzylsulfonium. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-(trifluoromethyl)benzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Sulfonium salts based on combination of the foregoing examples are included.

Iodonium salts are salts of iodonium cations with sulfonates. Exemplary iodonium cations include aryl iodonium cations such as diphenyliodonium, bis(4-tert-butylphenyl)iodonium, 4-tert-butoxyphenylphenyliodonium, and 4-methoxyphenylphenyliodonium. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-(trifluoromethyl)benzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, and methanesulfonate. Iodonium salts based on combination of the foregoing examples are included.

Exemplary sulfonyldiazomethane compounds include bissulfonyldiazomethane compounds and sulfonyl-carbonyldiazomethane compounds such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, and tert-butoxycarbonyl-4-methylphenylsulfonyldiazomethane.

N-sulfonyloxyimide photoacid generators include combinations of imide skeletons with sulfonates. Exemplary imide skeletons are succinimide, naphthalene dicarboxylic acid imide, phthalimide, cyclohexyldicarboxylic acid imide, 5-norbornene-2,3-dicarboxylic acid imide, and 7-oxabicyclo[2.2.1]-5-heptene-2,3-dicarboxylic acid imide. Exemplary sulfonates include trifluoromethanesulfonate, nonafluorobutanesulfonate, heptadecafluorooctanesulfonate, 2,2,2-trifluoroethanesulfonate, pentafluorobenzenesulfonate, 4-trifluoromathylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate.

Benzoinsulfonate photoacid generators include benzoin tosylate, benzoin mesylate, and benzoin butanesulfonate.

Pyrogallol trisulfonate photoacid generators include pyrogallol, phloroglucinol, catechol, resorcinol, and hydroquinone, in which all hydroxyl groups are substituted by trifluoromethanesulfonate, nonafluorobutanesulfonate, heptadecafluorooctanesulfonata, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, or methanesulfonate.

Nitrobenzyl sulfonate photoacid generators include 2,4-dinitrobenzyl sulfonates, 2-nitrobenzyl sulfonates, and 2,6-dinitrobenzyl sulfonates, with exemplary sulfonates including trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, and methanesulfonate. Also useful are analogous nitrobenzyl sulfonate compounds in which the nitro group on the benzyl side is substituted by trifluoromethyl.

Sulfone photoacid generators include bis(phenylsulfonyl)methane, bis(4-methylphenylsulfonyl)methane, bis(2-naphthylsulfonyl)methane, 2,2-bis(phenylsulfonyl)propane, 2,2-bis(4-methylphenylsulfonyl)propane, 2,2-bis(2-naphthylsulfonyl)propane, 2-methyl-2-(p-toluenesulfonyl)propiophenone, 2-cyclohexylcarbonyl-2-(p-toluenesulfonyl)propane, and 2,4-dimethyl-2-(p-toluenesulfonyl)pentan-3-one.

Photoacid generators in the form of glyoxime derivatives include bis-O-(p-toluenesulfonyl)-a-dimethylglyoxime, bis-O-(p-toluenesulfonyl)-α-diphenylglyoxime, bis-O-(p-toluenesulfonyl)-α-dicyclohexylglyoxime, bis-O-(p-toluenesulfonyl)-2,3-pentanedioneglyoxime, bis-O-(p-toluenesulfonyl)-2-methyl-3,4-pentanedioneglyoxime, bis-O-(n-butanesulfonyl)-α-dimethylglyoxime, bis-O-(n-butanesulfonyl)-α-diphenylglyoxime, bis-O-(n-butanesulfonyl)-α-dicyclohexylglyoxime, bis-O-(n-butanesulfonyl)-2,3-pentanedioneglyoxime, bis-O-(n-butanesulfonyl)-2-methyl-3,4-pentanedioneglyoxime, bis-O-(methanesulfonyl)-α-dimethylglyoxime, bis-O-(trifluoromethanesulfonyl)-α-dimethylglyoxime, bis-O-(1,1,1-trifluoroethanesulfonyl)-a-dimethylglyoxime, bis-O-(tert-butanesulfonyl)-α-dimethylglyoxime, bis-O-(perfluorooctanesulfonyl)-α-dimethylglyoxime, bis-O-(cyclohexylsulfonyl)-α-dimethylglyoxime, bis-O-(benzenesulfonyl)-α-dimethylglyoxime, bis-O-(p-fluorobenzenesulfonyl)-α-dimethylglyoxime, bis-O-(p-tert-butylbenzenesulfonyl)-α-dimethylglyoxime, bis-O-(xylenesulfonyl)-a-dimethylglyoxime, and bis-O-(camphorsulfonyl)-α-dimethylglyoxime.

Among these, the preferred PAGs are sulfonium salts, bissulfonyldiazomethanes, and N-sulfonyloxyimides.

Although the optimum anion of the generated acid varies with such factors as ease of scission of the acid labile group in the polymer, an anion which is non-volatile and not extremely highly diffusive is generally selected. Appropriate anions include anions of benzenesulfonic acid, toluenesulfonic acid, 4-(4-toluenesulfonyloxy)benzenesulfonic acid, pentafluorobenzenesulfonic acid, 2,2,2-trifluoroethanesulfonic acid, nonafluorobutanesulfonic acid, heptadecafluorooctanesulfonic acid, and camphorsulfonic acid.

The photoacid generator (B) is added to the chemically amplified positive resist composition in an amount of 0.5 to 15 parts, preferably 1 to 8 parts by weight per 80 parts by weight of the base resin. Less than 0.5 part of the PAG may lead to a poor sensitivity whereas a resist composition containing more than 15 parts of the PAG may have a low resolution and lose heat resistance due to the excess of monomeric fraction.

Component (C) is a nonionic fluorine compound which is a nonionic fluorinated organosiloxane compounds having the general formula (1), and which functions as a surfactant

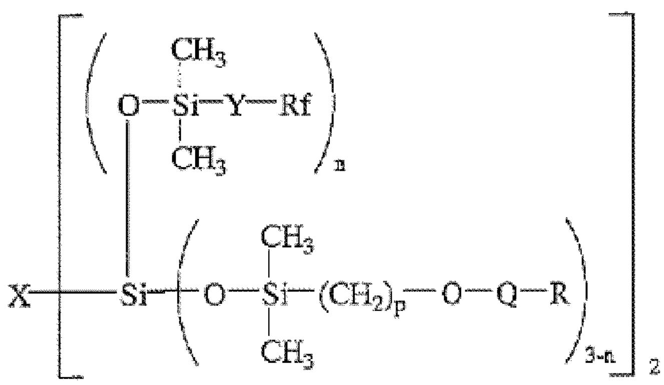

(1)

Herein Rf is a perfluoroalkyl group of 5 to 30 carbon atoms containing at least one ether bond in the molecular chain, Q is a polyether group consisting of a homopolymer chain of ethylene glycol or propylene glycol or a copolymer chain of ethylene glycol and propylene glycol, R is hydrogen or $C_1$-$C_4$ alkyl, X is a divalent linking group excluding oxygen atom, Y is a divalent linking group, p is an integer of at least 3, and n is a positive number in the range: $0 < n < 3$, and p = 3-6.

More particularly, Rf is a perfluoroalkyl group of 5 to 30 carbon atoms, preferably 8 to 20 carbon atoms, containing at least one ether bond in the molecular chain. If the carbon count exceeds the range, the compound has an increased overall molecular weight and a somewhat reduced solubility in solvents, which is undesirable as the surfactant. If the carbon count is below the range, the compound fails to take full advantage of the fluorinated group and to exert a high surface activating effect.

Examples of Rf are shown below.

$-CF_2CF_2CF_2OCF_2CF_3$

$-CF_2CF_2CF_20CF_2CF_2CF_20CF_3$

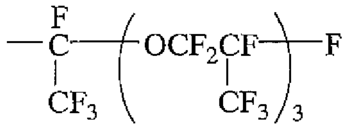

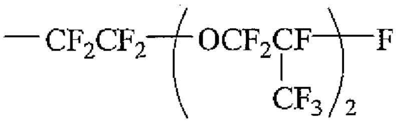

Preferably Rf is a group having the formula (2):

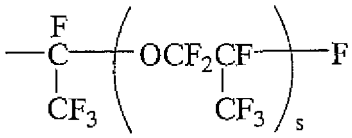

(2)

wherein s is an integer of 1 to 9.

The nonionic fluorinated organosiloxane compound of formula (1) wherein Rf is a perfluoroalkyl group containing at least one ether bond is more effective for reducing surface tension than the perfluoroalkyl-modified compound, provided that the degree of fluorine modification is identical. Then an equivalent effect is exerted by a smaller amount of the compound added.

In formula (1), Q is a polyether group. This polyether group may be a homopolymer chain of ethylene glycol, a homopolymer chain of propylene glycol or a copolymer chain of ethylene glycol and propylene glycol (inclusive of block polymerization and random polymerization). A choice may be made, depending on a particular application of the nonionic fluorinated organosiloxane compound.

The degree of polymerization of the polyether group may be determined by taking into account the hydrophobic fluorinated organic group Rf. When the polyether group is a homopolymer chain of ethylene glycol, the average degree of polymerization is preferably 3 to 20, more preferably 3 to 12. When a homopolymer chain of propylene glycol which is less hydrophilic than ethylene glycol is used, a polymer chain having a relatively high degree of polymerization is preferred, specifically an average degree of polymerization of 100 to 200. In the case of a copolymer chain of ethylene glycol and propylene glycol, it typically has a content of propylene glycol of 0.1 to 50 mol%, preferably 2 to 10 mol% based on the overall polyether group and an average degree of polymerization of 10 to 150.

Examples of Q are shown below.

$-(CH_2CH_2O)_3-$

$-(CH_2CH_2O)_{20}-$

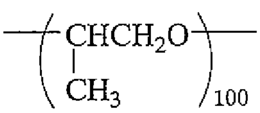

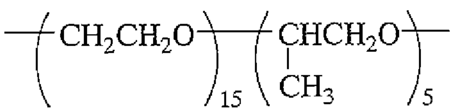

R is hydrogen or $C_1$-$C_4$ alkyl. Suitable alkyl groups include methyl, ethyl, n-propyl, isopropyl, n-butyl and isobutyl. Preferably R is hydrogen, methyl or n-butyl.

X is a divalent linking group excluding oxygen atom, for example, $C_2$-$C_{10}$ alkylene or fluoroalkylene. Inter alia, ethylene and $-CH_2CH_2C_6F_{12}CH_2CH_2-$ are preferred for ease of preparation.

Y is a divalent linking group, preferably hydrocarbon group, typically $C_2$-$C_{10}$ alkylene. The linking group may be separated by an ether bond (-O-), and alkylene groups which are separated by (-CONH-) are also included. Examples of the linking group are shown below.

$-CH_2CH_2-$

$-CH_2CH_2CH_2-$

$-CH_2OCH_2CH_2-$

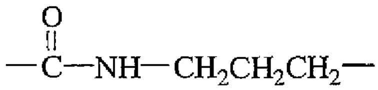

In formula (1), p is an integer of at least 3. For ease of preparation, $-(CH_2)_p-$ is an alkylene group of 3 to 6 carbon atoms, specifically propylene. The subscript n is a positive number in the range: $0 < n < 3$. By changing the value of n, properties of the fluorinated organosiloxane compound can be controlled.

As mentioned just above, the fluorinated organosiloxane compound allows its surfactant properties to be controlled by changing the value of n. The fluorinated organosiloxane compound of formula (1) has a fluorine content of 7 to 35% by weight, more preferably 9 to 30% by weight and a polyether content of 15 to 55% by weight, more preferably 30 to 45% by weight. Even more preferably the compound has a HLB (hydrophilic-lipophilic balance) of 4.0 to 10.0, especially 5.5 to 9.5.

The fluorinated organosiloxane compound having a fluorine content and a polyether content, and more preferably a HLB, all in the above ranges, has a very high surface tension reducing capability and a good balance of solubility in solvents and is thus very effective as the surfactant. Thus the resist composition formulated using the compound displays excellent coating uniformity, ameliorates the edge crown phenomenon that a resist coating builds up thicker near the periphery of the substrate, and ensures that an excellent resist pattern be formed. As long as the parameters are in the above ranges, the compound exerts a satisfactory surface activating effect even in a reduced amount of addition, which minimizes its influence on the properties of a resist film.

If the fluorine content and/or the HLB is below the range, the compound may not fully exert water and oil repellency inherent to fluorine, losing a surfactant function. If the fluorine content and/or the HLB is above the range, the compound may lose some solubility in solvent, failing to play the role of surfactant.

If the polyether group content is too low, the compound may lose some solubility in solvent. If the polyether group content is too high, which indicates a relatively low fluorine content, the compound may lose a surfactant function for the same reason as above.

It is noted that HLB is calculated according to the following equation.

$$\mathrm{HLB} = [\{(\text{molecular weight of alkylene oxide chain}) / (\text{molecular weight of surfactant})\} \times 100]/5$$

The fluorinated organosiloxane compound having formula (1) may be prepared simply, for example, by a hydrosilylation reaction of an organosilicon compound having the general formula (7):

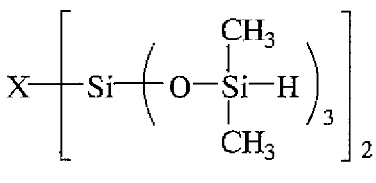

(7)

wherein X is as defined above with a fluorinated organic compound terminated with a reactive unsaturated hydrocarbon

bond and a polyether compound having the general formula (8):

$$CH_2=CH-(CH_2)_{p-2}-O-Q-R \qquad (8)$$

wherein Q, R, and p are as defined above in the presence of a platinum base catalyst.

The fluorinated organic compound terminated with a reactive unsaturated hydrocarbon bond may be a compound of Y'-Rf (wherein Y' is a group terminated with $CH_2$=CH, which becomes Y when hydrogen is added thereto) corresponding to Y-Rf in formula (1).

In the hydrosilylation reaction, the organosilicon compound of formula (7), the fluorinated organic compound terminated with a reactive unsaturated hydrocarbon bond, and the polyether compound of formula (8) are combined in a desired mix ratio such that the addition reaction product has a fluorine content, polyether content and HLB in the above-defined ranges when the fluorinated silicon compound is used as the surfactant.

Suitable platinum base catalysts include those commonly used in hydrosilylation reaction such as platinum and platinum compounds. The catalyst may be used in a catalytic amount. Hydrosilylation reaction may be performed under standard conditions, preferably at room temperature to 140°C for 0.5 to 6 hours.

The nonionic fluorinated organosiloxane compound containing a perfluoropolyether group and having a polyoxyalkylene type polyether bond is characterized in that a plurality of fluorine-modified groups or hydrophilic groups are attached to one silicon atom, and is thus effective as a fluorinated surfactant capable of substantially reducing surface tension even on use in smaller amounts, as compared with conventional fluorinated surfactants structured such that fluorine-modified groups and hydrophilic groups are attached 1:1. When the fluorinated organosilicon compound of the invention is used as a surfactant, the nonionic fluorinated organosiloxane compound containing a perfluoropolyether group and having a polyoxyalkylene type polyether bond, represented by formula (1), and having a fluorine content, a polyether content and a HLB value in the above-defined ranges may be used alone or in admixture of two or more.

When at least one nonionic fluorine compound selected from a nonionic fluorinated surfactant in the form of a perfluoroalkyl ethylene oxide adduct and a nonionic fluorinated organosiloxane compound containing a perfluoropolyether group and having a polyoxyalkylene type polyether bond, both as defined above, is added to the resist composition, the amount of addition is preferably 100 to 8,000 ppm, more preferably 100 to 6,000 ppm per 80 parts by weight of component (A). If the amount of the nonionic fluorine compound is less than 100 ppm, spin coating of the resist composition may entail a variation known as striation, indicating poor coating uniformity. More than 8,000 ppm of the nonionic fluorine compound may undesirably lower the softening temperature of the composition.

In one preferred embodiment, the resist composition further contains (D) a basic compound. The basic compound (D) is preferably a compound capable of suppressing the rate of diffusion when the acid generated by the PAG diffuses within the resist film. The inclusion of this type of basic compound holds down the rate of acid diffusion within the resist film, resulting in better resolution. In addition, it suppresses changes in sensitivity following exposure and reduces substrate and environment dependence, as well as improving the exposure latitude and the pattern profile.

Examples of basic compounds (D) include primary, secondary, and tertiary aliphatic amines, mixed amines, aromatic amines, heterocyclic amines, nitrogen-containing compounds having carboxyl group, nitrogen-containing compounds having sulfonyl group, nitrogen-containing compounds having hydroxyl group, nitrogen-containing compounds having hydroxyphenyl group, alcoholic nitrogen-containing compounds, amide derivatives, and imide derivatives.

Examples of suitable primary aliphatic amines include ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, and tetraethylenepentamine. Examples of suitable secondary aliphatic amines include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, and N,N-dimethyltetraethylenepentamine. Examples of suitable tertiary aliphatic amines include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N=-tetramethylmethylenediamine, N,N,N',N'-tetramethylethylenediamine, and N,N,N',N'-tetramethyltetraethylenepentamine.

Examples of suitable mixed amines include dimethylethylamine, methylethylpropylamine, benzylamine, phenethylamine, and benzyldimethylamine. Examples of suitable aromatic and heterocyclic amines include aniline derivatives (e.g., aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, and N,N-dimethyltoluidine), diphenyl(p-tolyl)amine, methyldiphenylamine, triphenylamine, phenylenediamine, naphthylamine, diaminonaphthalene, pyrrole derivatives (e.g., pyrrole, 2H-pyrrole, 1-methylpyrrole, 2,4-dimethylpyrrole, 2,5-dimethylpyrrole, and N-methylpyrrole), oxazole derivatives (e.g., oxazole and

isooxazole), thiazole derivatives (e.g., thiazole and isothiazole), imidazole derivatives (e.g., imidazole, 4-methylimidazole, and 4-methyl-2-phenylimidazole), pyrazole derivatives, furazan derivatives, pyrroline derivatives (e.g., pyrroline and 2-methyl-1-pyrroline), pyrrolidine derivatives (e.g., pyrrolidine, N-methylpyrrolidine, pyrrolidinone, and N-methylpyrrolidone), imidazoline derivatives, imidazolidine derivatives, pyridine derivatives (e.g., pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, and dimethylaminopyridine), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (e.g., quinoline and 3-quinolinecarbonitrile), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives.

Examples of suitable nitrogen-containing compounds having carboxyl group include aminobenzoic acid, indolecarboxylic acid, and amino acid derivatives (e.g. nicotinic acid, alanine, alginine, aspartic acid, glutamic acid, glycine, histidine, isoleucine, glycylleucine, leucine, methionine, phenylalanine, threonine, lysine, 3-aminopyrazine-2-carboxylic acid, and methoxyalanine). Examples of suitable nitrogen-containing compounds having sulfonyl group include 3-pyridinesulfonic acid and pyridinium p-toluenesulfonate. Examples of suitable nitrogen-containing compounds having hydroxyl group, nitrogen-containing compounds having hydroxyphenyl group, and alcoholic nitrogen-containing compounds include 2-hydroxypyridine, aminocresol, 2,4-quinolinediol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl)piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyjulolidine, 3-quinuclidinol, 3-tropanol, 1-methyl-2-pyrrolidine ethanol, 1-aziridine ethanol, N-(2-hydroxyethyl)phthalimide, and N-(2-hydroxyethyl)isonicotinamide. Examples of suitable amide derivatives include formamide, N-methylformamide, N,N-dimethylformamide, acetamide, N-methylacetamide, N,N-dimethylacetamide, propionamide, and benzamide. Suitable imide derivatives include phthalimide, succinimide, and maleimide.

In addition, basic compounds of the following general formula (D)-1 may also be included alone or in admixture.

$$N(U)_u(V)_{3-u} \qquad \text{(D)-1}$$

In the formula, u is equal to 1, 2 or 3; V is independently hydrogen or a straight, branched or cyclic alkyl group of 1 to 20 carbon atoms which may contain a hydroxyl or ether moiety; and U is independently selected from groups of the following general formulas (U)-1 to (U)-3, and two or three U may bond together to form a ring.

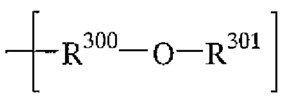

(X)-1

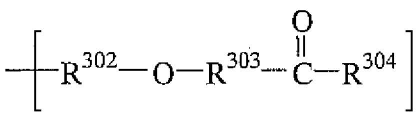

(X)-2

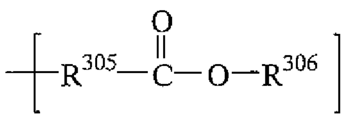

(X)-3

In the formulas, $R^{300}$, $R^{302}$ and $R^{305}$ are independently a straight or branched $C_1$-$C_4$ alkylene group. $R^{301}$ and $R^{304}$ are independently hydrogen, or a straight, branched or cyclic $C_1$-$C_{20}$ alkyl group which may contain at least one hydroxyl, ether or ester moiety or lactone ring. $R^{303}$ is a single bond or a straight or branched $C_1$-$C_4$ alkylene group. $R^{306}$ is a straight, branched or cyclic $C_1$-$C_{20}$ alkyl group which may contain at least one hydroxyl, ether or ester moiety or lactone ring.

Illustrative examples of the basic compounds of formula (D)-1 include tris(2-methoxymethoxyethyl)amine, tris{2-(2-methoxyethoxy)ethyl}amine, tris{2-(2-methoxyethoxymethoxy)ethyl}amine, tris{2-(1-methoxyethoxy)ethyl}amine, tris{2-(1-ethoxyethoxy)ethyl}amine, tris{2-(1-ethoxypropoxy)ethyl}amine, tris[2-{2-(2-hydroxyethoxy)ethoxy}ethyl]amine, 4,7,13,16,21,24-hexaoxa-1,10-diazabicyclo[8.8.8]hexacosane, 4,7,13,18-tetraoxa-1,10-diazabicyclo[8.5.5]eicosane, 1,4,10,13-tetraoxa-7,16-diazabicyclooctadecane, 1-aza-12-crown-4, 1-aza-15-crown-5, 1-aza-18-crown-6, tris(2-formyloxyethyl)amine, tris(2-acetoxyethyl)amine, tris(2-propionyloxyethyl)amine, tris(2-butyryloxyethyl)amine, tris(2-isobutyryloxyethyl)amine, tris(2-valeryloxyethyl)amine, tris(2-pivaloyloxyethyl)amine, N,N-bis(2-acetoxyethyl)-2-(acetoxyacetoxy)ethylamine, tris(2-methoxycarbonyloxyethyl)amine, tris(2-tert-butoxycarbonyloxyethyl)amine, tris[2-(2-oxopropoxy)ethyl]amine, tris[2-(methoxycarbonylmethyl)oxyethyl]amine, tris[2-(tert-butoxycarbonylmethyloxy)ethyl]amine, tris[2-(cyclohexyloxycarbonylmethyloxy)ethyl]amine, tris(2-methoxycarbonylethyl)amine, tris(2-ethoxycarbonylethyl)amine, N,N-bis(2-hydroxyethyl)-2-(methoxycarbonyl)ethylamine, N,N-bis(2-acetoxyethyl)-2-(methoxycarbonyl)ethylamine, N,N-bis(2-hydroxyethyl)-2-(ethoxycarbonyl)ethylamine, N,N-bis(2-acetoxyethyl)-2-(ethoxycarbonyl)ethylamine, N,N-bis(2-hydroxyethyl)-2-(2-methoxyethoxycarbonyl)ethylamine, N,N-bis(2-acetoxyethyl)-2-(2-methoxyethoxycarbonyl)ethylamine, N,N-bis(2-hydroxyethyl)-2-(2-hydroxyethoxycarbonyl)ethylamine, N,N-bis(2-acetoxyethyl)-2-(2-acetoxyethoxycarbonyl)ethylamine, N,N-bis(2-hydroxyethyl)-2-[(methoxycarbonyl)methoxycarbonyl]-ethylamine, N,N-bis(2-acetoxyethyl)-2-[(methoxycarbonyl)methoxycarbonyl]-ethylamine, N,N-bis(2-hydroxyethyl)-2-(2-oxopropoxycarbonyl)ethylamine, N,N-bis(2-acetoxyethyl)-2-(2-oxopropoxycarbonyl)ethylamine, N,N-bis(2-hydroxyethyl)-2-(tetrahydrofurfuryloxycarbonyl)-ethylamine, N,N-bis(2-acetoxyethyl)-2-(tetrahydrofurfuryloxycarbonyl)-ethylamine, N,N-bis(2-hydroxyethyl)-2-[(2-oxotetrahydrofuran-3-yl)oxycarbonyl]ethylamine, N,N-bis(2-acetoxyethyl)-2-[(2-oxotetrahydrofuran-3-yl)oxy-carbonyl]ethylamine, N,N-bis{2-hydroxyethyl}-2-(4-hydroxybutoxycarbonyl)ethylamine, N,N-bis(2-formyloxyethyl)-2-(4-formyloxybutoxycarbonyl)-ethylamine, N,N-bis(2-formyloxyethyl)-2-(2-formyloxyethoxycarbonyl)-ethylamine, N,N-bis(2-methoxyethyl)-2-(methoxycarbonyl)ethylamine, N-(2-hydroxyethyl)-bis[2-(methoxycarbonyl)ethyl]amine, N-(2-acetoxyethyl)-bis[2-(methoxycarbonyl)ethyl]amine, N-(2-hydroxyethyl)-bis[2-(ethoxycarbonyl)ethyl]amine, N-(2-acetoxyethyl)-bis[2-(ethoxycarbonyl)ethyl]amine, N-(3-hydroxy-1-propyl)-bis[2-(methoxycarbonyl)ethyl]amine, N-(3-acetoxy-1-propyl)-bis[2-(methoxycarbonyl)ethyl]amine, N-(2-methoxyethyl)-bis[2-(methoxycarbonyl)ethyl]amine, N-butyl-bis[2-(methoxycarbonyl)ethyl]amine, N-butyl-bis[2-(2-methoxyethoxycarbonyl)ethyl]amine, N-methyl-bis(2-acetoxyethyl)amine, N-ethyl-bis(2-acetoxyethyl)amine, N-methyl-bis(2-pivaloyloxyethyl)amine, N-ethyl-bis[2-(methoxycarbonyloxy)ethyl]amine, N-ethyl-bis[2-(tert-butoxycarbonyloxy)ethyl]amine, tris(methoxycarbonylmethyl)amine, tris(ethoxycarbonylmethyl)amine, N-butyl-bis(methoxycarbonylmethyl)amine, N-hexyl-bis(methoxycarbonylmethyl)amine, and β-(diethylamino)-δ-valerolactone.

The basic compounds may be used alone or in admixture of two or more. The basic compound (E) is preferably formulated in an amount of 0 to 2 parts, and especially 0.01 to 1 part by weight per 80 parts by weight of component (A). More than 2 parts of the basic compound may result in too low a sensitivity.

In most embodiments, an organic solvent is used to prepare the resist composition in solution form. Suitable organic solvents include ketones such as cyclohexanone, 2-hepatanone, 3-heptanone, and 4-heptanone; alcohols such as 3-methoxybutanol, 3-methyl-3-methoxybutanol, 1-methoxy-2-propanol, and 1-ethoxy-2-propanol; ethers such as propylene glycol monomethyl ether, ethylene glycol monomethyl ether, propylene glycol monoethyl ether, propylene glycol dimethyl ether, diethylene glycol dimethyl ether, ethylene glycol tert-butyl ether methyl ether (or 1-tert-butoxy-2-methoxyethane), and ethylene glycol tert-butyl ether ethyl ether (or 1-tert-butoxy-2-ethoxyethane); and esters such as propylene glycol monomethyl ether acetate, propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and methyl β-methoxyisobutyrate. Inter alia, preference is given to 1-ethoxy-2-propanol having a high solubility of resist components, or propylene glycol monomethyl ether acetate (inclusive of α and β types) having a high solubility of resist components and safety.

The organic solvent may be used alone or in admixture of two or more and is preferably added in an amount of 50 to 750 parts, more preferably 100 to 500 parts by weight per 80 parts by weight of component (A).

In the resist composition, other optional components may be added, for example, a light absorbing substance for reducing diffuse reflection from the substrate, a compound having 1,2-naphthoquinonediazidesulfonyl group in the molecule, and a dissolution accelerator. Such optional components may be added in conventional amounts as long as they do not compromise the benefits of the invention.

Suitable light absorbing substances include azo compounds such as 2-benzeneazo-4-methylphenol and 4-hydroxy-4'-dimethylaminoazobenzene, and curcumin.

The compounds having 1,2-naphthoquinonediazidesulfonyl group in the molecule include compounds having in the molecule a 1,2-naphthoquinonediazidesulfonyl group represented by the general formula (9) or (10).

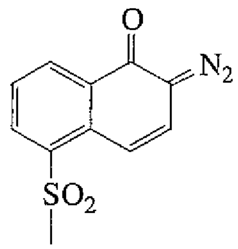

(9)

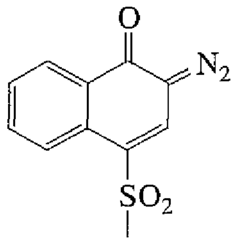

(10)

Examples of the parent compound into which a 1,2-naphthoquinonediazidesulfonyl group is introduced include tri- or tetrahydroxybenzophenone, ballast molecules having a phenolic hydroxyl group as represented by the general formula (11), and novolac resins comprising recurring units of the following formula (16) and having a Mw of 2,000 to 20,000, preferably 3,000 to 10,000.

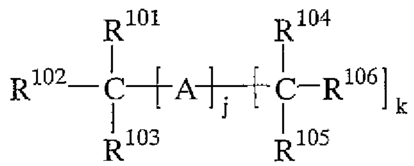

(11)

Herein $R^{101}$ to $R^{106}$ are each independently hydrogen, methyl, a group of formula (12), or a group of formula (13), j is an integer of 0 to 2, k is an integer of 0 to 2, with the proviso that j is 1 or 2 when k=0. When k is 0 and j is 1, A is hydrogen, methyl or a group of formula (12). When k is 0 and j is 2, one A is methylene or a group of formula (14), and the other A is hydrogen, methyl or a group of formula (12). When k is 1, A is methylene or a group of formula (14). When k is 2 and j is 1, A is methine or a group of formula (15). When j is 2, one A is methylene or a group of formula (14), and the other A is methine or a group of formula (15).

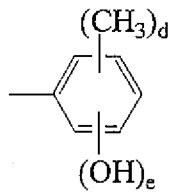

(12)

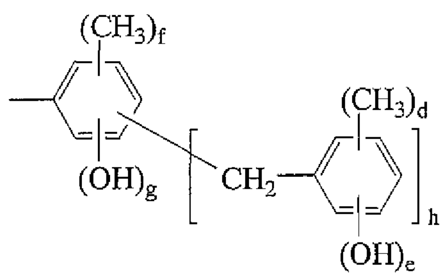

(13)

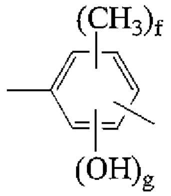

(14)

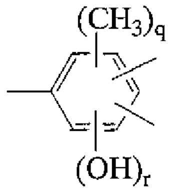

(15)

The subscripts d, e, f, g, h, q, and r each are an integer of 0 to 3, satisfying d+e ≤ 5, f+g ≤ 4, and q+r ≤ 3.

The low nuclear compound (or ballast molecule) of formula (11) is preferably designed such that the number of benzene rings is 2 to 20, more preferably 2 to 10, and even more preferably 3 to 6 benzene rings, and a ratio of the number of phenolic hydroxyl groups to the number of benzene rings is from 0.5/1 to 2.5/1, more preferably from 0.7 to 2.0, and even more preferably from 0.8 to 1.5.

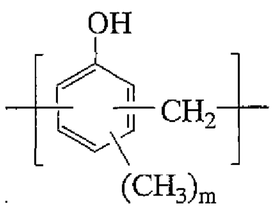

(16)

Herein, m is an integer of 0 to 3.

The novolac resin of formula (16) may be synthesized by carrying out condensation reaction of a phenol having the following formula (17) with an aldehyde by a standard method.

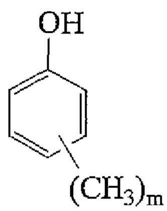

(17)

Herein, m is an integer of 0 to 3.

Examples of the phenol having formula (17) include o-cresol, m-cresol, p-cresol, and 3,5-xylenol, which may be used alone or in admixture. Examples of the aldehyde include formaldehyde, paraformaldehyde, acetaldehyde, and benzaldehyde, with formaldehyde being preferred.

The phenol of formula (17) and the aldehyde are preferably combined in a molar ratio of 0.2/1 to 2/1, more preferably 0.3 to 2.

The preferred method of introducing a 1,2-naphthoquinonediazidesulfonyl group into the parent compound is by dehydrochlorination condensation reaction of 1,2-naphthoquinonediazidesulfonyl chloride with phenolic hydroxyl group in the presence of a base catalyst. When the parent compound is a ballast molecule of formula (11) or tri- or tetrahydroxybenzophenone, the hydrogen of phenolic hydroxyl group is preferably substituted by 1,2-naphthoquinonediazidesulfonyl in a proportion of 10 to 100 mol%, more preferably 50 to 100 mol%. When the parent compound is a novolac resin of formula (16), the hydrogen of phenolic hydroxyl group is preferably substituted by 1,2-naphthoquinonediazidesulfonyl in a proportion of 2 to 50 mol%, more preferably 3 to 27 mol%.

The compound having a 1,2-naphthoquinonediazidesulfonyl group in the molecule is preferably added in an amount of 0.1 to 15 parts, more preferably 0.5 to 10 parts by weight to 80 parts by weight of the base resin. Less than 0.1 parts of the compound may be ineffective for improving the resolution of the resist composition whereas more than

15 parts may adversely affect the sensitivity.

Typically the dissolution accelerator is a low nuclear compound of formula (11), defined above, in which the number of benzene rings is 2 to 20, more preferably 2 to 10, and even more preferably 3 to 6 benzene rings, and a ratio of the number of phenolic hydroxyl groups to the number of benzene rings is from 0.5/1 to 2.5/1, more preferably from 0.7 to 2.0, and even more preferably from 0.8 to 1.5. Examples of the low nuclear compound are shown below as (E-1) to (E-43).

(E-1)

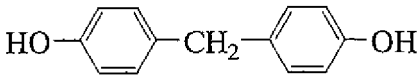

(E-2)

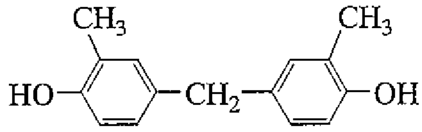

(E-3)

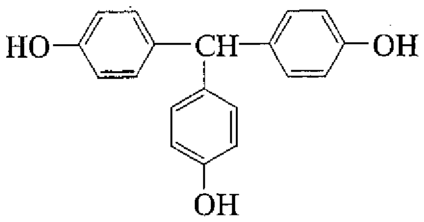

(E-4)

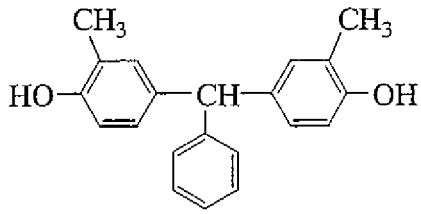

(E-5)

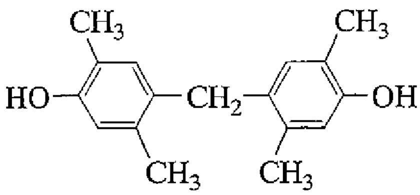

(E-6)

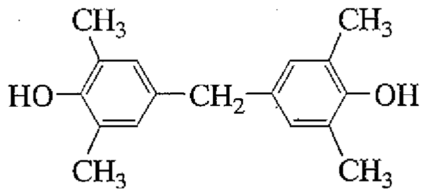

(E-7)

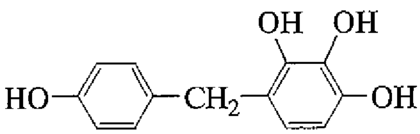

(E-8)

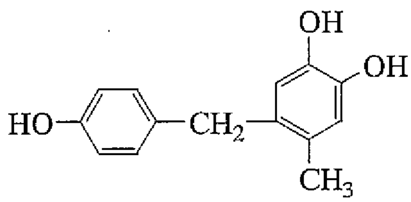

(E-9)

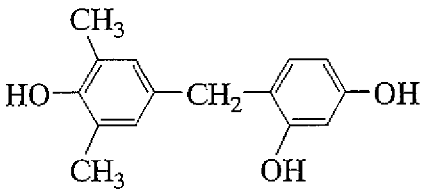

(E-10)

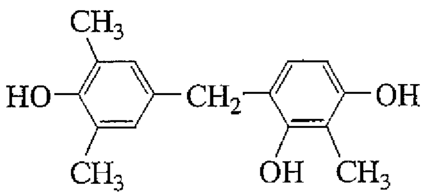

(E-11)

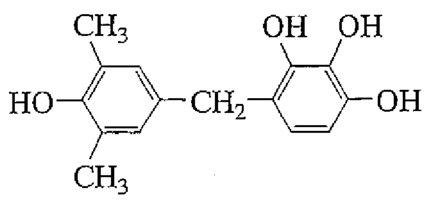

(E-12)

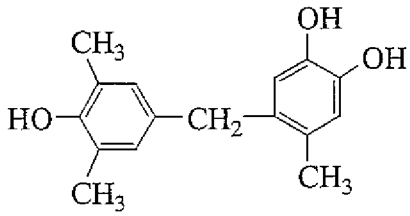

(E-13)

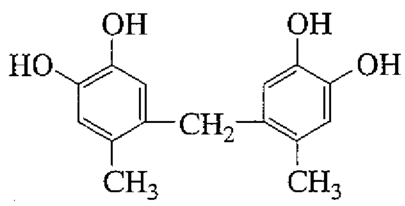

(E-14)

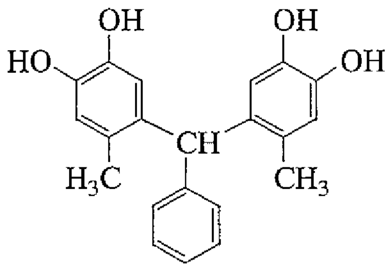

(E-15)

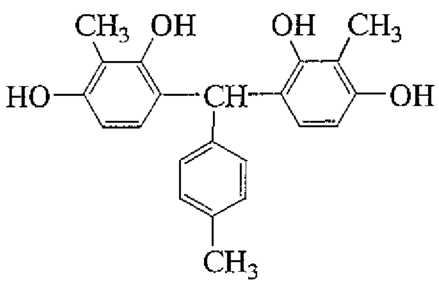

(E-16)

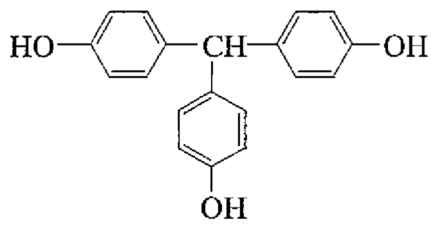

(E-17)

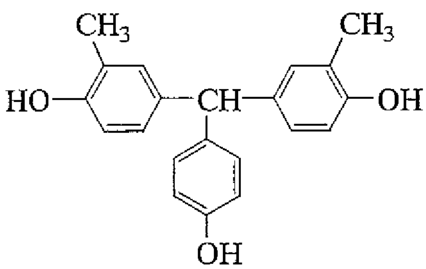

(E-18)

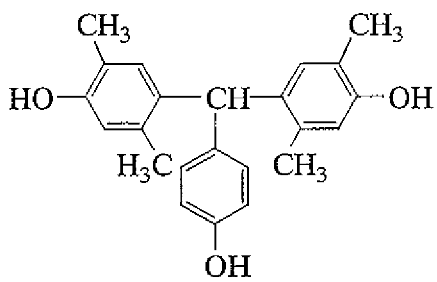

(E-19)

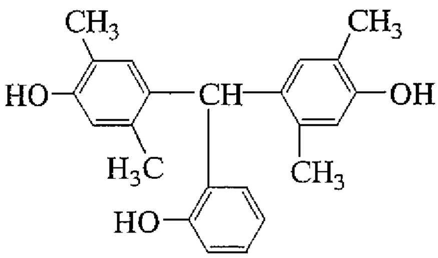

(E-20)

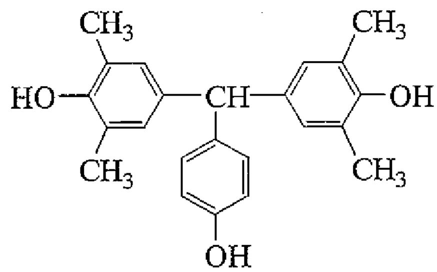

(E-21)

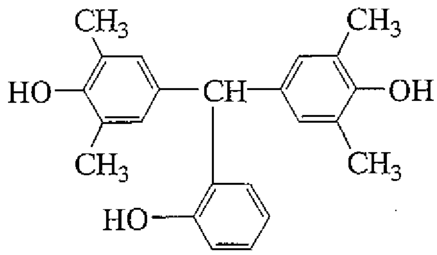

(E-22)

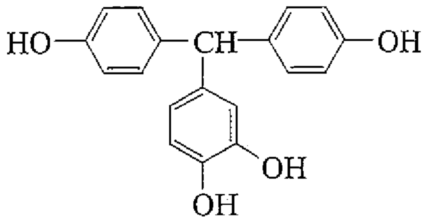

(E-23)

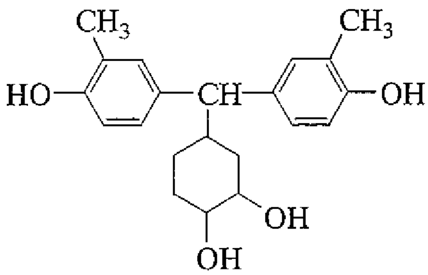

(E-24)

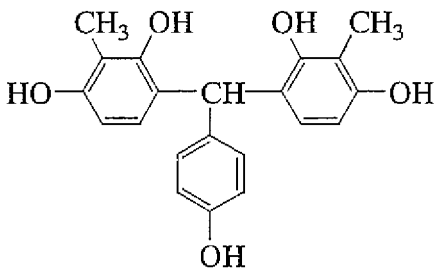

(E-25)

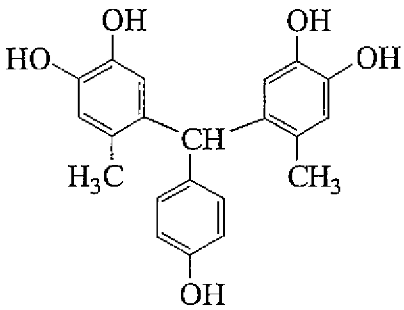

(E-26)

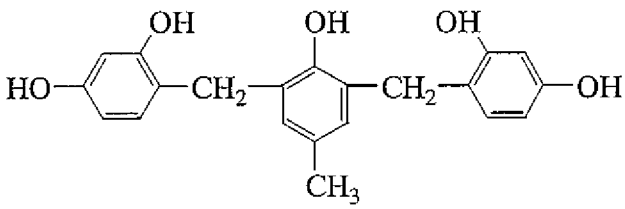

(E-27)

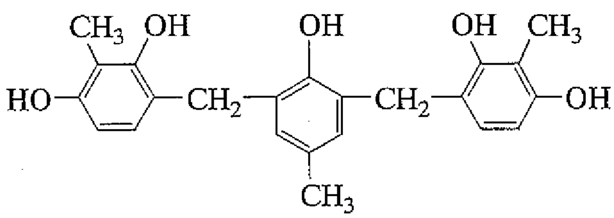

(E-28)

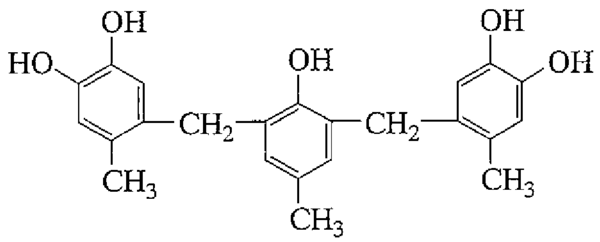

(E-29)

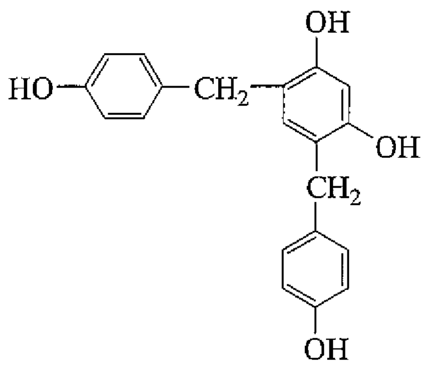

(E-30)

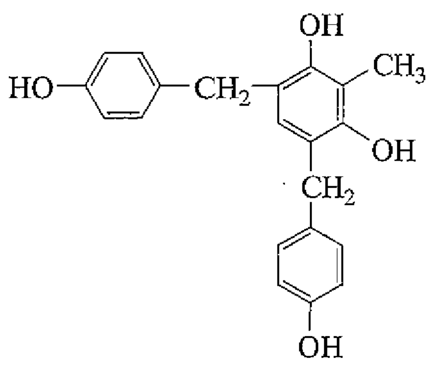

(E-31)

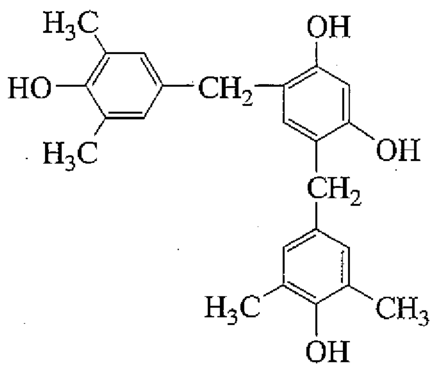

(E-32)

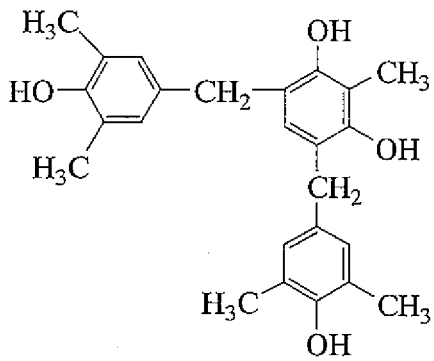

(E-33)

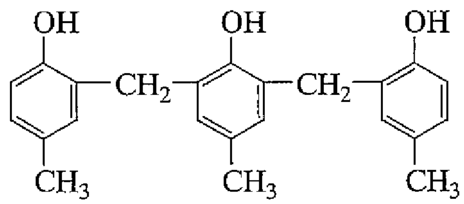

(E-34)

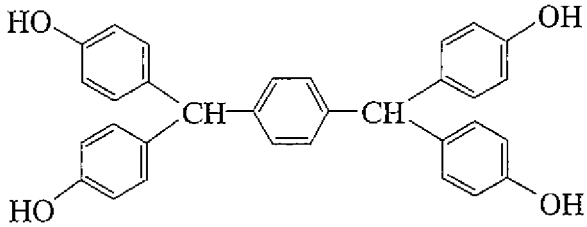

(E-35)

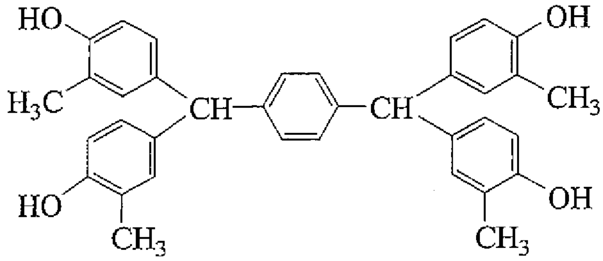

(E-36)

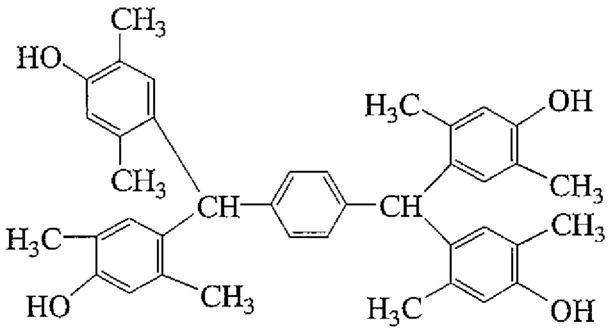

(E-37)

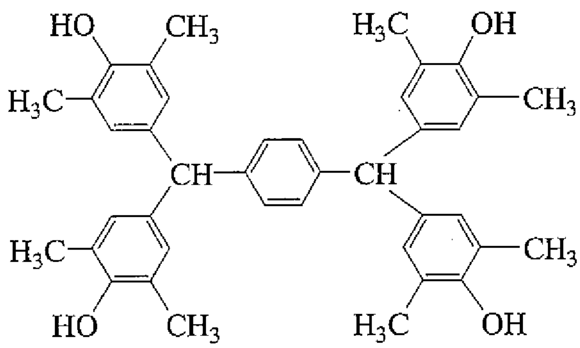

(E-38)

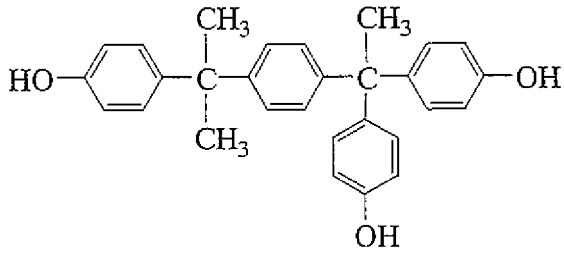

(E-39)

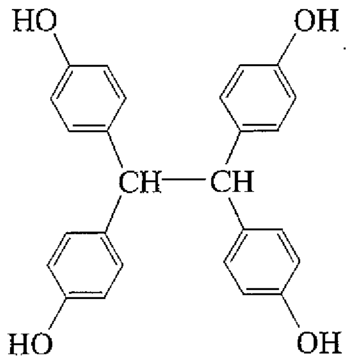

(E-40)

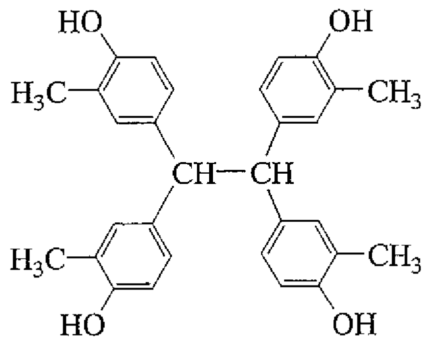

(E-41)

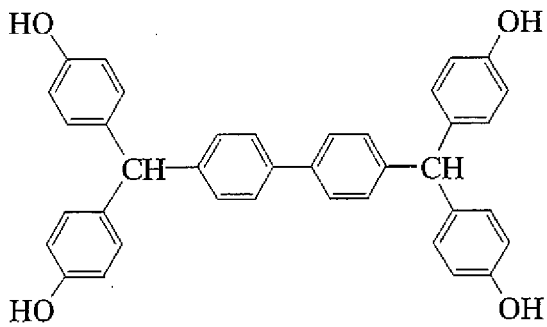

(E-42)

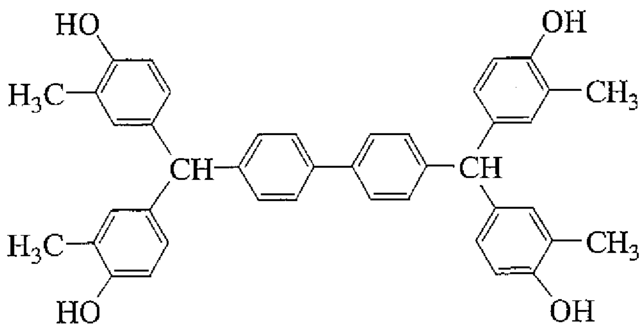

(E-43)

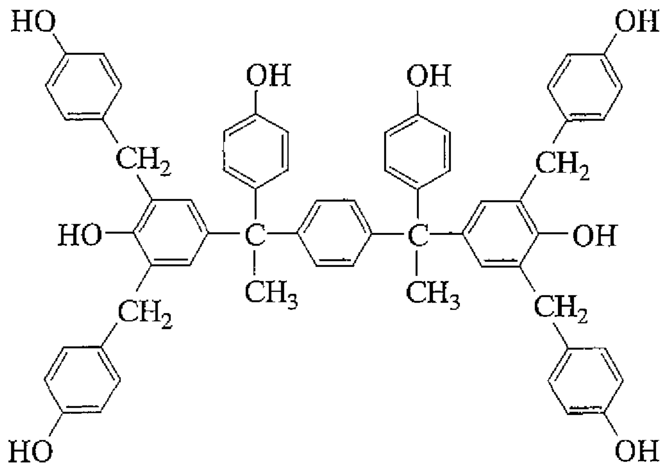

(E-44)

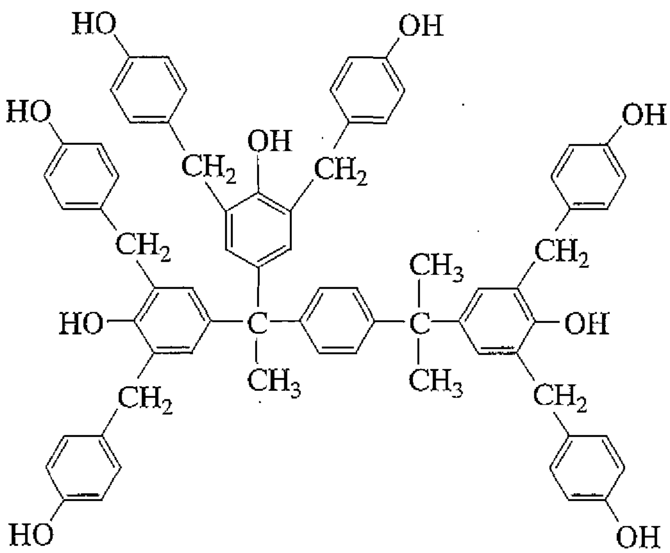

The dissolution accelerator, which may be used alone or in admixture, is preferably added in an amount of 0 to 10 parts, more preferably 0.05 to 5 parts by weight to 80 parts by weight of the base resin. More than 10 parts of the dissolution accelerator may adversely affect resolution and heat resistance.

Process

The positive resist composition of the invention may be used to form a pattern. First the composition is coated onto a substrate by a standard technique. The type of substrate is not particularly limited, and examples of the substrate include Si, Ni, Fe, Zn, Mg, Co, Al, Pt, Pd, Ta, Au, Cu, Ti, Cr, NiFe, SiON, alumina, other oxide film, and nitride film substrates. The resist coating is preferably prebaked at a temperature of 90 to 130°C for 1 to 15 minutes to form a resist film. The thickness of resist film is not particularly limited, but usually ranges from 5 to 100 μm, preferably 5 to 80 μm, and more preferably 10 to 60 μm. The resist film is exposed through a photomask. Exposure is made using UV radiation having a wavelength of at least 150 nm, preferably at least 193 nm, and more preferably at least 248 nm, and typically radiation having a wavelength of up to 500 nm, such as i, h and g-lines. If desired, the film may be baked (PEB) at 70 to 130°C for 1 to 5 minutes. Thereafter the resist film is developed with a developer. Examples of the developer include aqueous solutions of organic bases such as tetramethylammonium hydroxide (TMAH) and aqueous solutions of inorganic

bases such as sodium hydroxide, potassium hydroxide and potassium metaborate. In this way, a positive resist pattern is formed on the substrate.

Next, electrolytic or electroless plating may be carried out on the resist pattern-bearing substrate. Electroplating may be effectively carried out because the resist composition has satisfactory acid resistance. A metal material may be deposited to form a metal pattern on the substrate. Examples of the metal to be plated include Au, Ag, Cu, Fe, Ni and the like. The metal film preferably has a thickness of 1 to 100 μm, more preferably 5 to 70 μm, and even more preferably 10 to 60 μm.

## EXAMPLE

Examples of the invention are given below by way of illustration and not by way of limitation. All parts are by weight.

### Examples 1 to 8 & Comparative Examples 1, 2

A resist solution was prepared by dissolving 80 parts of a base resin (Polymer 1 having recurring units identified below), 2 parts of an acid generator (PAG-1) and 0.1 part of triethanolamine as a basic compound in 65 parts of propylene glycol monomethyl ether acetate (PGMEA). Further, a nonionic fluorinated surfactant in the form of a perfluoroalkyl ethylene oxide adduct, a nonionic fluorinated organosiloxane compound containing a perfluoropolyether group and having a polyoxyalkylene type polyether bond (Si-1 or Si-2), or a conventional surfactant, identified below, in Comparative Example was added in the amount shown in Table 1. The solution was filtered through a membrane filter having a pore size of 1.0 μm. The resist solution was spin coated onto a substrate (8-inch silicon wafer) and soft baked on a hot plate at 130° C for 300 seconds to form a resist film having a desired thickness of 50.0 μm.

The resist film as coated was visually observed to inspect striation and coating unevenness. In Table 1, the resist film was rated good (O) when neither striation nor coating unevenness were found, and poor (X) when striation and coating unevenness were found.

The thickness of the resist film was measured by a film thickness measurement system (RE-3100 by Dainippon Screen Co., Ltd.) at 29 points which were spaced 6 mm apart along a diameter of the substrate. An average of film thickness and a variation or range of film thickness as an index of coating uniformity are shown in Table 2. Edge crown was evaluated by measuring the thickness of the resist film near the periphery of the substrate (5 mm inside the substrate edge). A difference between the film thickness near the substrate periphery and the average film thickness is reported in Table 2 as edge crown.

Next, using an i-line stepper NSR-175517A (Nikon Corp., NA = 0.50), the resist film was exposed to i-line through a reticle. The resist film was baked (PEB) at 80°C for 120 seconds and developed with a 2.38 wt% tetramethylammonium hydroxide aqueous solution for 300 seconds to form a 50-μm line-and-space pattern. This was followed by deionized water rinsing and drying.

The resist pattern on the Si substrate was observed under a scanning electron microscope (SEM) to determine the exposure dose which provided 1:1 resolution of a 50-μm line-and-space pattern. The pattern printed at this dose was judged scum-free (O in Table 2) when the pattern profile was satisfactory and no resist residue was found in the spaces, and poor (X in Table 2) when the pattern profile was unsatisfactory and/or resist residue was found.

Polymer 1

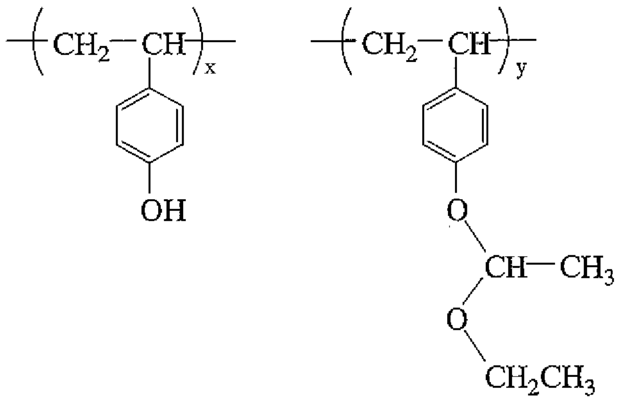

(Polymer-1)

x = 0.28, y = 0.72

Mw = 18,900

Mw/Mn = 1.3

PAG-1

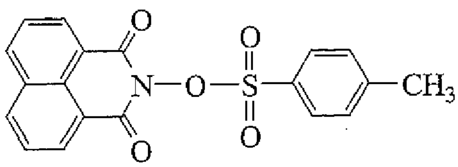

(PAG-1)

Table 1

| | Surfactant | Addition amount (ppm) |
|---|---|---|
| Example 1 | S-420 *1 | 800 |
| Example 2 | S-420 *1 | 2,500 |
| Example 3 | Si-1 | 2,500 |
| Example 4 | Si-1 | 800 |
| Example 5 | Si-1 | 600 |
| Example 6 | Si-2 | 2,500 |
| Example 7 | Si-2 | 800 |
| Example 8 | Si-2 | 600 |
| Comparative Example 1 | FC-430 *2 | 800 |
| Comparative Example 2 | FC-430 *2 | 2,500 |

*1 S-420: perfluoroalkyl ethylene oxide adduct type surfactant, by AGC Seimi Chemical Co., Ltd. Reference surfactant. Not a surfactant of formula (1).
*2 FC-430: nonionic perfluorooctanesulfonic acid derivative, by 3M-Sumitomo Co., Ltd.

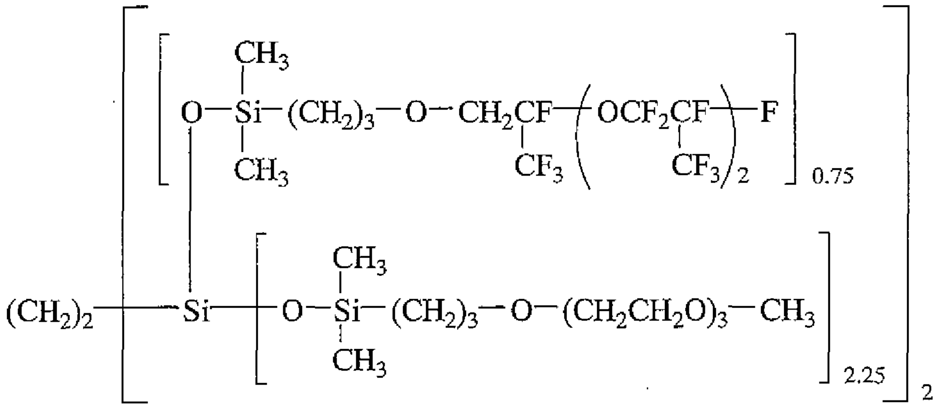

(Si-1)

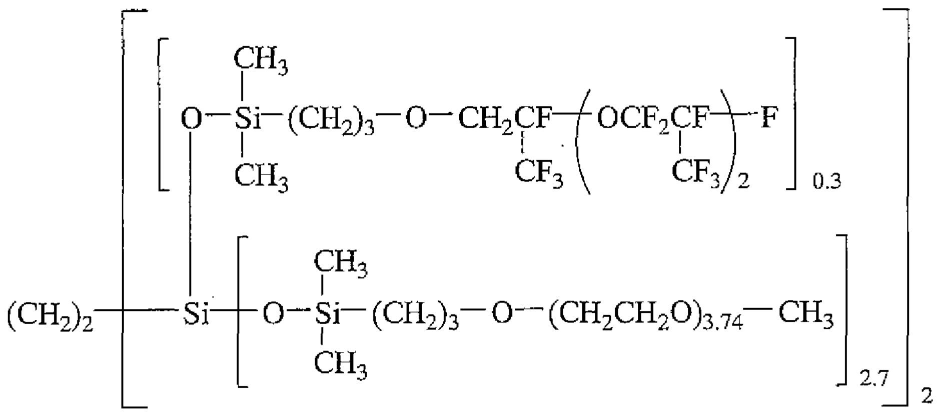

(Si-2)

Table 2

| | Coating uniformity, striation | Film thickness (μm) | Film thickness range (μm) | Edge crown (μm) | Scum on resist pattern |
|---|---|---|---|---|---|
| Example 1* | ○ | 50.1 | 2.59 | 6.2 | ○ |
| Example 2* | ○ | 51.7 | 1.41 | 4.7 | ○ |
| Example 3 | ○ | 51.0 | 2.88 | 5.1 | ○ |
| Example 4 | ○ | 50.9 | 2.86 | 5.7 | ○ |
| Example 5 | ○ | 50.8 | 2.50 | 6.1 | ○ |
| Example 6 | ○ | 51.1 | 2.97 | 5.3 | ○ |
| Example 7 | ○ | 51.0 | 3.10 | 5.6 | ○ |
| Example 8 | ○ | 51.1 | 3.71 | 6.0 | ○ |
| Comparative Example 1 | × | 49.9 | 6.01 | 25.8 | × |
| Comparative Example 2 | × | 50.2 | 5.11 | 20.8 | × |
| *Reference examples - Not part of the invention. | | | | | |

Examples 9 to 16 & Comparative Examples 3 to 5

A resist solution was prepared by dissolving 80 parts of a base resin (Polymer 2 having recurring units identified

below), 3 parts of an acid generator (PAG-2) and 0.2 part of Amine 1 as a basic compound in 65 parts of PGMEA. Further, an amount of a nonionic fluorine compound was added as shown in Table 3. The solution was filtered through a membrane filter having a pore size of 1.0 μm. The resist solution was spin coated onto a copper substrate and soft baked on a hot plate at 140°C for 300 seconds to form a resist film having a desired thickness of 40 μm.

The thickness of the resist film was measured by a film thickness measurement system (RE-3100 by Dainippon Screen Co., Ltd.) at 29 points which were spaced 6 mm apart along a diameter of the substrate. An average of film thickness and a variation or range of film thickness as an index of coating uniformity are shown in Table 4. Edge crown was evaluated by measuring the thickness of the resist film near the periphery of the substrate (5 mm inside the substrate edge). A difference between the film thickness near the substrate periphery and the average film thickness is reported in Table 4 as edge crown.

Next, using an excimer laser stepper NSR-2005EX (Nikon Corp., NA = 0.50), the resist film was exposed to radiation through a reticle. The resist film was baked (PEB) at 110°C for 120 seconds and developed with a 2.38 wt% tetramethylammonium hydroxide aqueous solution for 100 seconds to form a 40-μm 1:3 contact hole pattern. This was followed by deionized water rinsing and drying.

The resist pattern on the Cu substrate was observed under a SEM to determine the exposure dose which provided a resolution of a 40-μm 1:3 contact hole pattern. The pattern printed at this dose was judged scum-free (○ in Table 4) when the pattern profile was satisfactory and no resist residue was found in the spaces, and poor (X in Table 4) when the pattern profile was unsatisfactory and/or resist residue was found.

Polymer 2

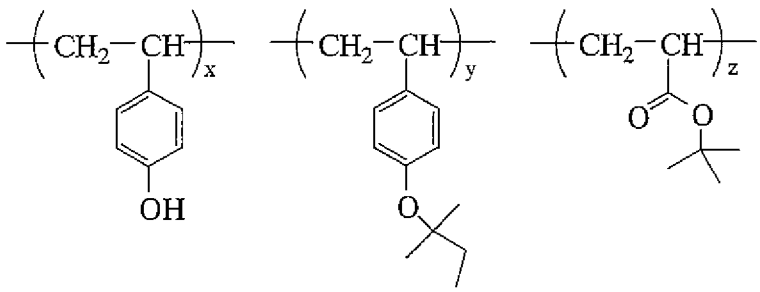

(Polymer-2)

$x = 0.71,\ y = 0.20,\ z = 0.09$

Mw = 12,000

Mw/Mn = 1.85

PAG-2

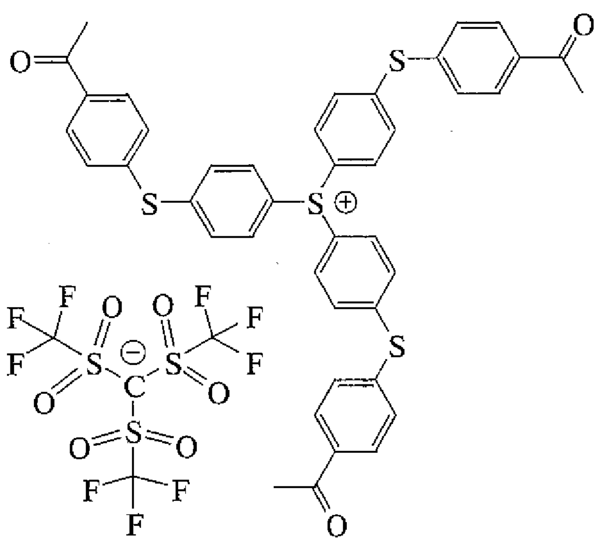

(PAG-2)

Amine 1

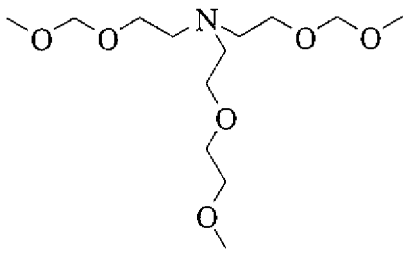

(Amine-1)

Table 3

| | Surfactant | Addition amount (ppm) |
|---|---|---|
| Example 9 | S-420 *1 | 1,000 |
| Example 10 | S-420 *1 | 3,000 |
| Example 11 | Si-1 | 3,000 |
| Example 12 | Si-1 | 800 |
| Example 13 | Si-1 | 600 |
| Example 14 | Si-2 | 3,000 |
| Example 15 | Si-2 | 800 |
| Example 16 | Si-2 | 600 |
| Comparative Example 3 | FC-430 *2 | 1,000 |
| Comparative Example 4 | FC-430 *2 | 3,000 |
| Comparative Example 5 | Megafac R08 *3 | 3,000 |

*1 S-420: perfluoroalkyl ethylene oxide adduct type surfactant, by AGC Seimi Chemical Co., Ltd. Reference surfactant. Not a surfactant of formula (1).
*2 FC-430: nonionic perfluorooctanesulfonic acid derivative, by 3M-Sumitomo Co., Ltd.
*3 Magafac R08: nonionic perfluorooctyl-terminated surfactant, by DIC Corp.

Table 4

| | Coating uniformity, striation | Film thickness (μm) | Film thickness range (μm) | Edge crown (μm) | Scum on resist pattern |
|---|---|---|---|---|---|
| Example 9* | ○ | 40.5 | 1.66 | 2.8 | ○ |
| Example 10* | ○ | 42.1 | 1.21 | 3.1 | ○ |
| Example 11 | ○ | 41.3 | 1.89 | 4.3 | ○ |
| Example 12 | ○ | 41.2 | 1.70 | 5.0 | ○ |
| Example 13 | ○ | 41.7 | 1.68 | 5.4 | ○ |
| Example 14 | ○ | 41.7 | 1.95 | 4.7 | ○ |
| Example 15 | ○ | 41.5 | 1.80 | 5.2 | ○ |
| Example 16 | ○ | 41.6 | 1.78 | 5.5 | ○ |

(continued)

| | Coating uniformity, striation | Film thickness (μm) | Film thickness range (μm) | Edge crown (μm) | Scum on resist pattern |
|---|---|---|---|---|---|
| Comparative Example 3 | × | 49.9 | 5.01 | 20.1 | × |
| Comparative Example 4 | × | 40.3 | 5.21 | 19.9 | × |
| Comparative Example 5 | ○ | 50.9 | 4.00 | 19.2 | ○ |
| * Reference examples. Not part of the claimed invention. | | | | | |

**Claims**

**1.** A chemically amplified positive resist composition adapted for exposure to UV radiation having a wavelength of at least 150 nm, comprising

(A) a polymer having an acidic functional group protected with an acid labile group, which is alkali insoluble, but turns alkali soluble when the acid labile group is eliminated, said polymer comprising recurring units having a phenolic hydroxyl group as represented by the general formula (3) wherein the hydrogen of phenolic hydroxyl group is, in part, substituted by an acid labile group of one or more type, in an average proportion of more than 0 mol% to 80 mol% based on the total hydrogen atoms of phenolic hydroxyl groups, the polymer having a weight average molecular weight (Mw) of 3,000 to 300,000, as measured by GPC versus polystyrene standards:

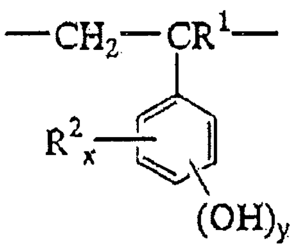

(3)

wherein $R^1$ is hydrogen or methyl, $R^2$ is a straight, branched or cyclic $C_1$-$C_8$ alkyl group, x is 0 or a positive integer, y is a positive integer, satisfying $x+y \leq 5$, or comprising recurring units represented by the general formula (6):

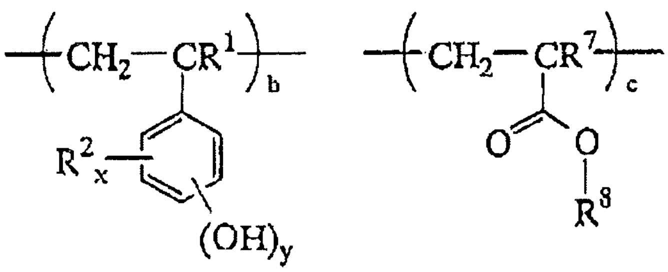

(6)

wherein $R^1$ is hydrogen or methyl, $R^2$ is a straight, branched or cyclic $C_1$-$C_8$ alkyl group, x is 0 or a positive integer, y is a positive integer, satisfying $x+y \leq 5$, $R^7$ is hydrogen or methyl, $R^8$ is an acid labile group which is eliminated through reaction with acid, the subscripts b and c are positive numbers in the range:

$0.50 \leq b \leq 0.85$, $0.15 \leq c \leq 0.50$, and $b+c = 1$,

(B) an acid generator, and

(C) at least one nonionic fluorinated organosiloxane compound having the general formula (1):

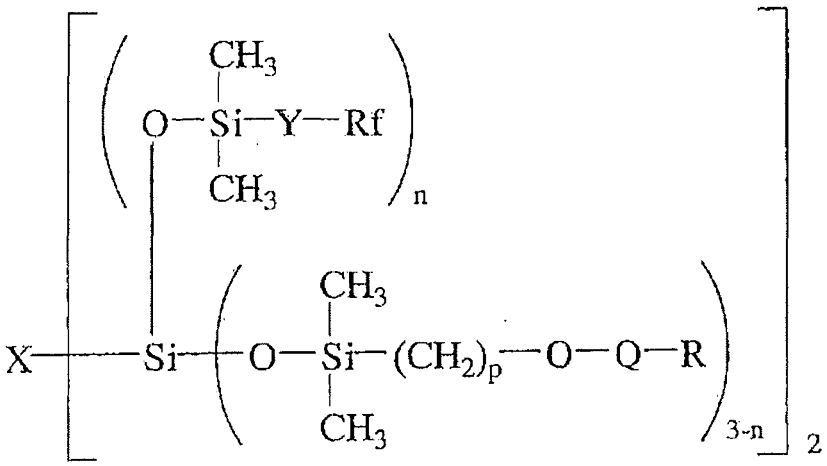

(1)

wherein Rf is a perfluoroalkyl group of 5 to 30 carbon atoms containing at least one ether bond in the molecular chain, Q is a polyether group of a homopolymer chain of ethylene glycol or propylene glycol or a copolymer chain of ethylene glycol and propylene glycol, R is hydrogen or $C_1$-$C_4$ alkyl, X is a divalent linking group excluding oxygen atom, Y is a divalent linking group, p is an integer of at least 3, and n is a positive number in the range: $0 < n < 3$, wherein the nonionic fluorinated organosiloxane compound has a fluorine content of 7 to 35% by weight and a polyether content of 15 to 55% by weight, and p = 3-6 in formula (1).

**2.** The composition of claim 1 wherein Rf in formula (1) is a group having the formula (2):

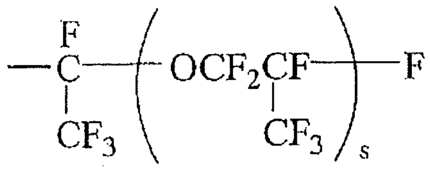

(2)

wherein s is an integer of 1 to 9.

**3.** The composition of claim 1 or 2 wherein X is $C_2$-$C_{10}$ alkylene or fluoroalkylene, and Y is $C_2$-$C_{10}$ alkylene which may be separated by an ether bond, or

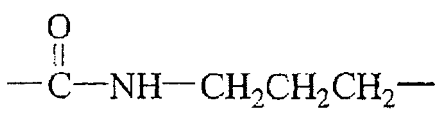

**4.** The composition of any one of claims 1 to 3 wherein the nonionic fluorinated organosiloxane compound (C) is present in an amount of 100 to 8,000 ppm per 80 parts by weight of component (A).

**5.** The composition of any one of claims 1 to 4 wherein the acid labile group in the polymer comprising recurring units having a phenolic hydroxyl group as represented by the general formula (3) is selected from groups having the general formulae (4) and (5), tert-alkyl, trialkylsilyl, and ketoalkyl groups:

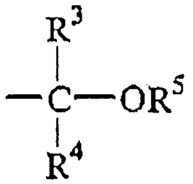

(4)

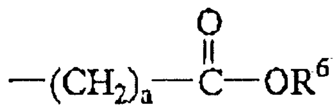

(5)

wherein $R^3$ and $R^4$ are each independently hydrogen or a straight or branched $C_1$-$C_6$ alkyl group, $R^5$ is a straight, branched or cyclic $C_1$-$C_{10}$ alkyl group, or a pair of $R^3$ and $R^4$, $R^3$ and $R^5$, or $R^4$ and $R^5$ may bond together to form a ring with the carbon atom or the carbon and oxygen atoms to which they are attached, each of participant $R^3$, $R^4$ and $R^5$ is a straight or branched $C_1$-$C_6$ alkylene group when they form a ring, $R^6$ is a tertiary alkyl group of 4 to 12 carbon atoms, and a is an integer of 0 to 6.

**6.** The composition of any one of claims 1 to 5 wherein in the recurring units of formula (6) the hydrogen of phenolic hydroxyl group is, in part, substituted by an acid labile group.

**7.** The composition of any one of claims 1 to 6 wherein the acid generator of component (B) is selected from sulfonium salt, iodonium salt, sulfonyldiazomethane, an N-sulfonyloxyimide acid generators.

**8.** The composition of any one of claims 1 to 7, further comprising (D) a basic compound.

**9.** Use of the composition of any one of claims 1 to 8 as a solder bump-forming resist material.

**10.** A pattern forming process comprising the steps of:

(i) coating the resist composition of any one of claims 1 to 8 onto a substrate and prebaking to form a resist film,
(ii) exposing the resist film to UV radiation having a wavelength of at least 150 nm through a photomask, and
(iii) optionally baking, and developing with a developer to form a resist pattern.

**11.** The process of claim 10, further comprising electrolytic plating or electroless plating to deposit a metal layer on the substrate, after the developing step (iii).

**12.** The process of claim 10 or 11 wherein the resist film has a thickness of 5 to 100 μm.

**13.** The process of claim 12 wherein the resist film has a thickness of 10 to 60 μm.

**Patentansprüche**

**1.** Chemisch verstärkte Positivresistzusammensetzung, welche für die Belichtung gegenüber UV-Strahlung mit einer Wellenlänge von mindestens 150 nm angepasst ist, umfassend

(A) ein Polymer mit einer sauren funktionellen Gruppe, geschützt durch eine säurelabile Gruppe, welche alkaliunlöslich ist, jedoch alkalilöslich wird, wenn die säurelabile Gruppe eliminiert wird, wobei das Polymer wiederkehrende Einheiten mit einer phenolischen Hydroxylgruppe, wie durch die allgemeine Formel (3) wiedergegeben, umfasst, wobei der Wasserstoff der phenolischen Hydroxylgruppe teilweise substituiert ist durch eine säurelabile Gruppe eines oder mehrerer Typen, in einem durchschnittlichen Anteil von mehr als 0 Mol-% bis 80 Mol-%, basierend auf den gesamten Wasserstoffatomen phenolischer Hydroxylgruppen, wobei das Polymer ein gewichtsmittleres Molekulargewicht (Mw) von 3.000 bis 300.000 aufweist, gemessen durch GPC gegenüber Polystyrol-Standards:

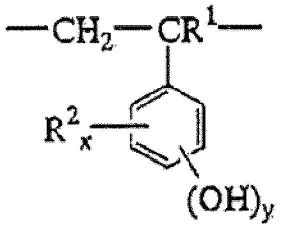

(3)

worin $R^1$ Wasserstoff oder Methyl ist, $R^2$ eine gerade, verzweigte oder zyklische $C_1$-$C_8$-Alkylgruppe ist, x 0 oder eine positive ganze Zahl ist, y eine positive ganze Zahl ist, wobei $x+y \leq 5$ erfüllt ist, oder umfassend wiederkehrende Einheiten, wiedergegeben durch die allgemeine Formel (6):

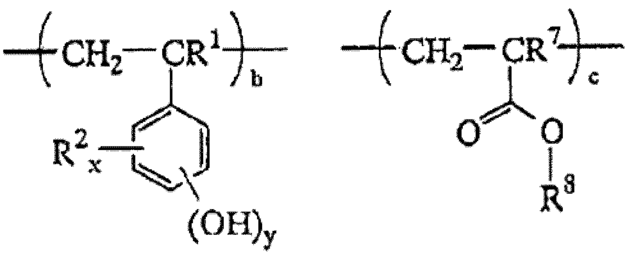

(6)

worin $R^1$ Wasserstoff oder Methyl ist, $R^2$ eine gerade, verzweigte oder zyklische $C_1$-$C_8$-Alkylgruppe ist, x 0 oder eine positive ganze Zahl ist, y eine positive ganze Zahl ist, wobei $x+y \leq 5$ erfüllt ist, $R^7$ Wasserstoff oder Methyl ist, $R^8$ eine säurelabile Gruppe ist, welche durch Umsetzung mit Säure eliminiert wird, wobei die tiefgestellten Zeichen b und c positive Zahlen sind, im Bereich:

$0{,}50 \leq b \leq 0{,}85$, $0{,}15 \leq c \leq 0{,}50$ und $b+c=1$,

(B) einen Säuregenerator, und
(C) mindestens eine nichtionische fluorierte Organosiloxanverbindung der allgemeinen Formel (1):

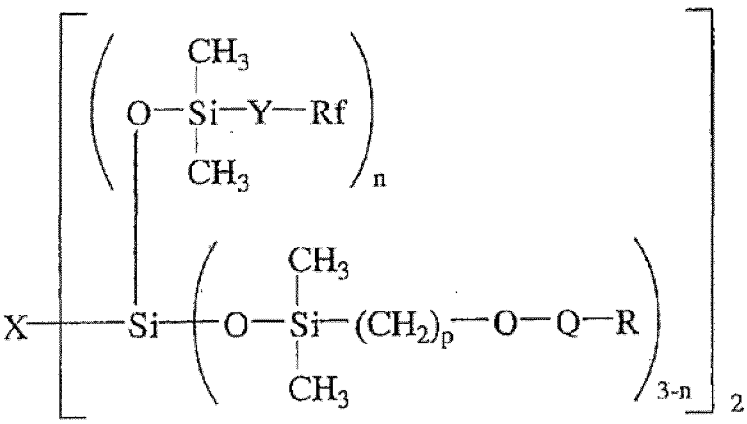

(1)

worin Rf eine Perfluoralkylgruppe mit 5 bis 30 Kohlenstoffatomen ist, welche mindestens eine Etherbindung in der Molekülkette enthält, Q eine Polyethergruppe einer Homopolymerkette von Ethylenglykol oder Propylenglykol oder einer Copolymerkette von Ethylenglykol und Propylenglykol ist, R Wasserstoff oder $C_1$-$C_4$-Alkyl ist, X eine zweiwertige Verbindungsgruppe ist, ausgenommen Sauerstoffatom, Y eine zweiwertige Verbindungsgruppe ist, p eine ganze Zahl von mindestens 3 ist, und n eine positive Zahl ist, im Bereich: $0 < n < 3$, wobei die nichtionische fluorierte Organosiloxanverbindung einen Fluorgehalt von 7 bis 35 Gewichts-% und einen Polyethergehalt von 15 bis 55 Gewichts-% aufweist, und p=3-6 in der Formel (1).

**2.** Zusammensetzung nach Anspruch 1, wobei Rf in Formel (1) eine Gruppe der Formel (2) ist:

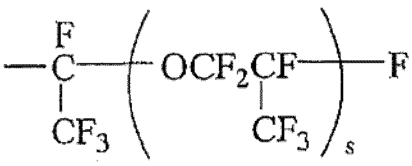 (2)

worin s eine ganze Zahl von 1 bis 9 ist.

**3.** Zusammensetzung nach Anspruch 1 oder 2, wobei X $C_2$-$C_{10}$-Alkylen oder -Fluoralkylen ist, und Y $C_2$-$C_{10}$-Alkylen ist, das durch eine Etherbindung getrennt sein kann, oder

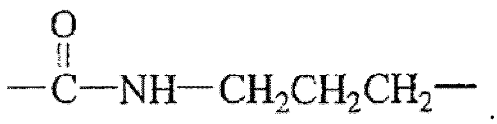

**4.** Zusammensetzung nach mindestens einem der Ansprüche 1 bis 3, wobei die nichtionische fluorierte Organosiloxanverbindung (C) in eine Menge von 100 bis 8.000 ppm pro 80 Gewichtsteile der Komponente (A) vorliegt.

**5.** Zusammensetzung nach einem der Ansprüche 1 bis 4, wobei die säurelabile Gruppe in dem Polymer, das wiederkehrende Einheiten mit einer phenolischen Hydroxylgruppe umfasst, wie durch die allgemeine Formel (3) wiedergegeben, aus Gruppen der allgemeinen Formeln (4) und (5), tert-Alkyl-, Trialkylsilyl- und Ketoalkylgruppen gewählt ist:

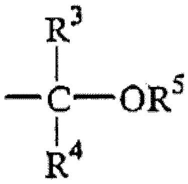 (4)

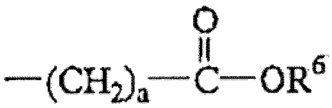 (5)

worin $R^3$ und $R^4$ jeweils unabhängig Wasserstoff oder eine gerade oder verzweigte $C_1$-$C_6$-Alkylgruppe sind, $R^5$ eine gerade, verzweigte oder zyklische $C_1$-$C_{10}$-Alkylgruppe ist, oder ein Paar aus $R^3$ und $R^4$, $R^3$ und $R^5$ oder $R^4$ und $R^5$ verbunden sein können zur Bildung eines Rings mit dem Kohlenstoffatom oder dem Kohlenstoff- und Sauerstoffatomen, an welche sie gebunden sind, jeder der Teilnehmer $R^3$, $R^4$ und $R^5$ eine gerade oder verzweigte $C_1$-$C_6$-Alkylengruppe ist, wenn diese einen Ring bilden, $R^6$ eine tertiäre Alkylgruppe mit 4 bis 12 Kohlenstoffatomen ist, und a eine ganze Zahl von 0 bis 6 ist.

**6.** Zusammensetzung nach mindestens einem der Ansprüche 1 bis 5, wobei in den wiederkehrenden Einheiten der Formel (6) der Wasserstoff der phenolischen Hydroxylgruppe teilweise durch eine säurelabile Gruppe substituiert ist.

**7.** Zusammensetzung nach mindestens einem der Ansprüche 1 bis 6, wobei der Säuregenerator der Komponente (B) gewählt ist aus Sulfoniumsalz-, Iodoniumsalz-, Sulfonyldiazomethan- und N-Sulfonyloximid-Säuregeneratoren.

**8.** Zusammensetzung nach mindestens einem der Ansprüche 1 bis 7, umfassend weiterhin (D) eine basische Verbindung.

**9.** Verwendung der Zusammensetzung gemäß mindestens einem der Ansprüche 1 bis 8 als ein Löthöcker-bildendes Resistmaterial.

**10.** Musterbildungsverfahren, umfassend die Schritte:

(i) Beschichten der Resistzusammensetzung gemäß mindestens einem der Ansprüche 1 bis 8 auf ein Substrat und thermisches Vorbehandeln zur Bildung eines Resistfilms,
(ii) Belichten des Resistfilms gegenüber UV-Strahlung mit einer Wellenlänge von mindestens 150 nm durch eine Photomaske, und
(iii) wahlweise thermisches Behandeln und Entwickeln mit einem Entwickler zur Bildung eines Resistmusters.

**11.** Verfahren nach Anspruch 10, umfassend weiterhin elektrolytisches Plattieren oder stromloses Plattieren zur Abscheidung einer Metallschicht auf dem Substrat, nach dem Entwicklungsschritt (iii).

**12.** Verfahren nach Anspruch 10 oder 11, wobei der Resistfilm eine Dicke von 5 bis 100 μm besitzt.

**13.** Verfahren nach Anspruch 12, wobei der Resistfilm eine Dicke von 10 bis 60 μm besitzt.

## Revendications

**1.** Composition de réserve positive chimiquement amplifiée adaptée pour une exposition à un rayonnement UV ayant une longueur d'onde d'au moins 150 nm, comprenant

(A) un polymère ayant un groupe fonctionnel acide protégé par un groupe labile acide, qui est insoluble dans un milieu alcalin, mais devient soluble dans un milieu alcalin lorsque le groupe labile acide est éliminé, ledit polymère comprenant des motifs répétés ayant un groupe hydroxyle phénolique comme représenté par la formule générale (3) dans laquelle l'atome d'hydrogène du groupe hydroxyle phénolique est, en partie, substitué par un groupe labile acide d'un ou plusieurs types, selon une proportion moyenne de plus de 0 % en moles à 80 % en moles, par rapport au nombre total d'atomes d'hydrogène des groupes hydroxyle phénoliques, le polymère ayant une masse moléculaire moyenne en masse (Mm) de 3000 à 300 000, comme mesurée par GPC par rapport à des standards de polystyrène :

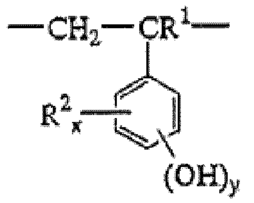

(3)

dans laquelle $R^1$ est un atome d'hydrogène ou un groupe méthyle, $R^2$ est un groupe alkyle en $C_1$ à $C_8$ linéaire, ramifié ou cyclique, x vaut 0 ou est un nombre entier positif, y est un nombre entier positif, satisfaisant $x+y \leq 5$, ou comprenant les motifs répétés représentés par la formule générale (6) :

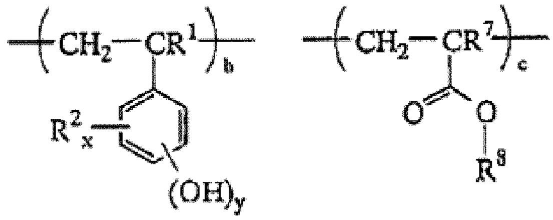

(6)

dans laquelle $R^1$ est un atome d'hydrogène ou un groupe méthyle, $R^2$ est un groupe alkyle en $C_1$ à $C_8$ linéaire, ramifié ou cyclique, x vaut 0 ou est un nombre entier positif, y est un nombre entier positif, satisfaisant $x+y \leq 5$, $R^7$ est un atome d'hydrogène ou un groupe méthyle, $R^8$ est un groupe labile acide qui est éliminé par une réaction avec un acide, les indices b et c sont des nombres positifs dans la plage :

$0,50 \leq b \leq 0,85$, $0,15 \leq c \leq 0,50$ et $b+c = 1$,

(B) un générateur d'acide, et

(C) au moins un composé d'organosiloxane fluoré non ionique répondant à la formule générale (1) :

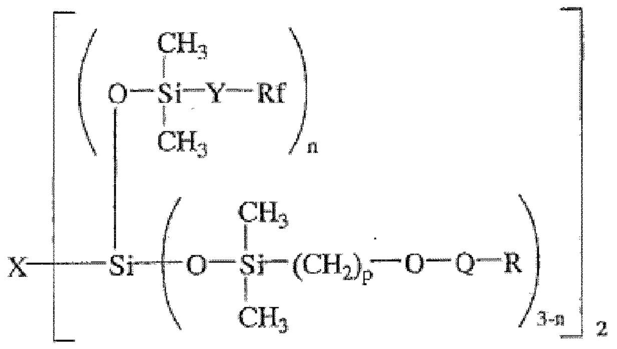

(1)

dans laquelle Rf est un groupe perfluoroalkyle de 5 à 30 atomes de carbone contenant au moins une liaison éther dans la chaîne moléculaire, Q est un groupe polyéther d'une chaîne homopolymère d'éthylène glycol ou de propylène glycol ou d'une chaîne copolymère d'éthylène glycol et de propylène glycol, R est un atome d'hydrogène ou un groupe alkyle en $C_1$ à $C_4$, X est un groupe liant divalent à l'exception d'un atome d'oxygène, Y est un groupe liant divalent, p est un entier d'au moins 3, et n est un nombre positif dans la plage : $0 < n < 3$, où le composé organosiloxane fluoré non ionique a une teneur en fluor de 7 à 35 % en poids et une teneur en polyéther de 15 à 55 % en poids, et p = 3 à 6 dans la formule (1).

2. Composition selon la revendication 1, dans laquelle Rf dans la formule (1) est un groupe répondant à la formule (2) :

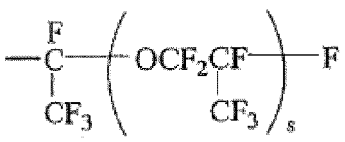

(2)

dans laquelle s est un nombre entier de 1 à 9.

3. Composition selon la revendication 1 ou 2, dans laquelle X est un groupe alkylène ou fluoroalkylène en $C_2$ à $C_{10}$, et Y est un groupe alkylène en $C_2$ à $C_{10}$ qui peut être séparé par une liaison éther, ou

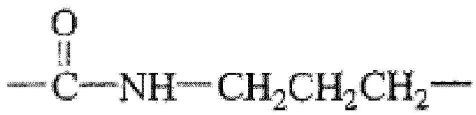

.

4. Composition selon l'une quelconque des revendications 1 à 3, dans laquelle le composé organosiloxane fluoré non ionique (C) est présent en une quantité de 100 à 8000 ppm pour 80 parties en poids du composant (A).

5. Composition selon l'une quelconque des revendications 1 à 4, dans laquelle le groupe labile acide dans le polymère comprenant des motifs répétés ayant un groupe hydroxyle phénolique comme représenté par la formule générale (3) est sélectionné parmi les groupes répondant aux formules générales (4) et (5), les groupes tert-alkyle, trialkylsilyle et cétoalkyle :

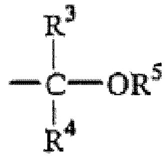

(4)

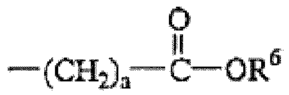

(5)

dans lesquelles $R^3$ et $R^4$ sont chacun indépendamment un atome d'hydrogène ou un groupe alkyle en $C_1$ à $C_6$ linéaire ou ramifiée, $R^5$ est un groupe alkyle en $C_1$ à $C_{10}$ linéaire, ramifié ou cyclique, ou $R^3$ et $R^4$, $R^3$ et $R^5$ ou $R^4$ et $R^5$ peuvent se lier ensemble pour former un cycle avec l'atome de carbone ou les atomes de carbone et d'oxygène auxquels ils sont attachés, chaque participant $R^3$, $R^4$ et $R^5$ est un groupe alkylène en $C_1$ à $C_6$ linéaire ou ramifié lorsqu'ils forment un cycle, $R^6$ est un groupe alkyle tertiaire de 4 à 12 atomes de carbone et a est un nombre entier de 0 à 6.

**6.** Composition selon l'une quelconque des revendications 1 à 5, dans laquelle dans les motifs répétés de la formule (6), l'atome d'hydrogène du groupe hydroxyle phénolique est, en partie, substitué par un groupe labile acide.

**7.** Composition selon l'une quelconque des revendications 1 à 6, dans laquelle le générateur d'acide du composant (B) est sélectionné parmi les générateurs d'acide de sel de sulfonium, sel d'iodonium, sulfonyldiazométhane, N-sulfonyloxyimide.

**8.** Composition selon l'une quelconque des revendications 1 à 7, comprenant en outre (D) un composé basique.

**9.** Utilisation de la composition selon l'une quelconque des revendications 1 à 8 en tant que matériau de réserve formant une bosse de soudure.

**10.** Procédé de formation d'un motif comprenant les étapes consistant à :

(i) revêtir la composition de réserve selon l'une quelconque des revendications 1 à 8 sur un substrat et précuire pour former un film de réserve,
(ii) exposer le film de réserve à un rayonnement UV ayant une longueur d'onde d'au moins 150 nm à travers un photomasque, et
(iii) facultativement cuire et développer avec un développeur pour former un motif de réserve.

**11.** Procédé selon la revendication 10, comprenant en outre un placage électrolytique ou un placage chimique pour déposer une couche de métal sur le substrat, après l'étape de développement (iii).

**12.** Procédé selon la revendication 10 ou 11, dans lequel le film de réserve a une épaisseur de 5 à 100 $\mu$m.

**13.** Procédé selon la revendication 12, dans lequel le film de réserve a une épaisseur de 10 à 60 $\mu$m.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP H06118660 A
- JP H11352700 A
- JP H11030856 A
- JP H11030865 A
- JP H11109629 A
- EP 1724332 A1
- EP 1798596 A2
- JP 2002006503 A
- JP H03047190 A